(19) Europäisches Patentamt
European Patent Office
Office européen des brevets

(11) Numéro de publication : **0 366 576 B1**

# (12) FASCICULE DE BREVET EUROPEEN

(45) Date de publication du fascicule du brevet : **03.03.93 Bulletin 93/09**

(51) Int. Cl.$^5$ : **C08G 73/12,** C08F 222/40, C08F 216/14, C08L 79/08

(21) Numéro de dépôt : **89420409.8**

(22) Date de dépôt : **24.10.89**

## (54) Polymères à groupements imides faits à partir de diamines encombrées.

(30) Priorité : **26.10.88 FR 8814375**

(43) Date de publication de la demande : **02.05.90 Bulletin 90/18**

(45) Mention de la délivrance du brevet : **03.03.93 Bulletin 93/09**

(84) Etats contractants désignés : **BE CH DE ES FR GB IT LI NL SE**

(56) Documents cités : **EP-A- 0 274 968**

(73) Titulaire : **CIBA-GEIGY AG
Klybeckstrasse 141
CH-4002 Basel (CH)**

(72) Inventeur : **Camberlin, Yves
68 bis, quai Clemenceau
F-69300 Caluire (FR)**
Inventeur : **Michaud, Philippe
19, rue du Tonkin
F-69100 Villeurbanne (FR)**

(74) Mandataire : **Zumstein, Fritz, Dr. et al
Zumstein & Klingseisen Patentanwälte
Bräuhausstrasse 4
W-8000 München 2 (DE)**

EP 0 366 576 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

Dans la demande de brevet français FR-A-2.608.613 on a décrit et revendiqué des polymères à groupements imides, pouvant se trouver sous forme de prépolymères thermodurcissables, qui comprennent le produit de réaction, à une température allant de 50°C à 300°C, entre :

- (a) un N,N'-bis-imide ou une association de plusieurs bis-imides de formule :

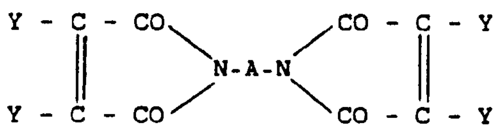

(I)

dans laquelle :

. les symboles Y, identiques ou différents, représentent chacun H, $CH_3$ ou Cl;

. le symbole A représente un radical divalent choisi dans le groupe constitué par les radicaux : cyclohexylène ; phénylènes ; méthyl-4 phénylène-1,3 ; méthyl-2 phénylène-1,3 ; méthyl-5 phénylène-1,3 ; diéthyl-2,5 méthyl-3 phénylène-1,4 ; et les radicaux de formule :

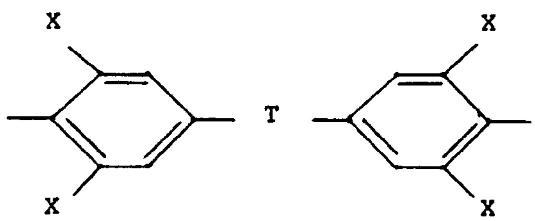

dans laquelle T représente un lien valentiel simple ou un groupement :

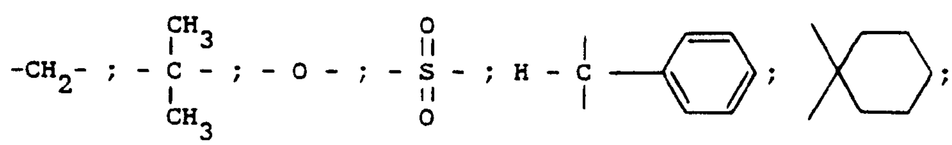

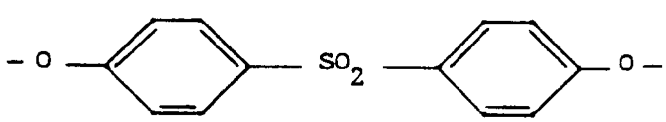

et les symboles X, identiques ou différents, représentent chacun un atome d'hydrogène, un radical méthyle, éthyle ou isopropyle ;

- (b) une ou plusieurs diamine(s) biprimaire(s) encombrée(s) prise(s) dans le groupe formé par :

(i) les espèces répondant à la formule générale :

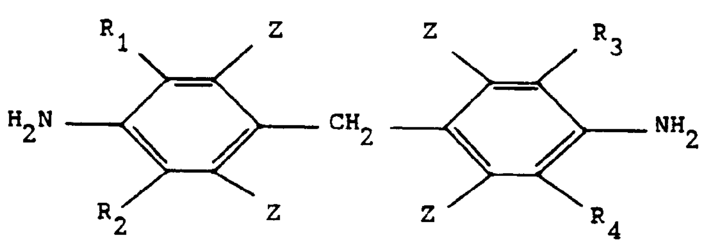

(II)

dans laquelle :

. les symboles $R_1$, $R_2$, $R_3$ et $R_4$, identiques ou différents, représentent chacun un radical méthyle, éthyle, propyle ou isopropyle ;

. les symboles Z, identiques ou différents, représentent chacun un atome d'hydrogène ou un atome de chlore ;

(2i) et les espèces répondant à la formule générale :

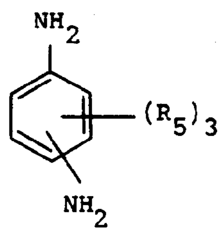

(III)

dans laquelle :

. les radicaux amino sont en position méta ou para, l'un par rapport à l'autre ;

. les symboles $R_5$, identiques ou différents, représentent chacun un radical méthyle, éthyle, propyle ou isopropyle ;

- (c) éventuellement un ou plusieurs monomère(s) non halogéné(s) autre(s) qu'un bis-imide de formule (I) et comprenant une ou plusieurs double(s) liaison(s) carbone-carbone polymérisable(s) ;
- et (d) éventuellement un composé de type imidazole.

Un premier avantage lié à la mise en oeuvre de l'invention conforme à la demande française précitée provient de l'encombrement stérique du réactif aminé (b) qui est responsable d'une réactivité plus faible des constituants du milieu de polymérisation, par comparaison avec ce qui se passe avec les polyamino-bis maléimides issus de diamines non encombrées. Cette réactivité plus faible des constituants du milieu de polymérisation présente un intérêt particulier non seulement pour la réalisation de pièces faisant appel à une mise en oeuvre d'un prépolymère à l'état fondu, mais encore pour la réalisation de pièces faisant appel à une mise en oeuvre d'un prépolymère sous forme de solution dans un solvant. En effet, la viscosité du prépolymère à l'état fondu ou celle de la solution du prépolymère évolue plus faiblement et cela facilite grandement la mise en oeuvre du prépolymère, notamment dans des applications nécessitant une durée de travail de plusieurs heures.

Un second avantage lié à la mise en oeuvre de l'invention conforme à la demande française précitée réside dans le fait que les polymères sont préparés sans prendre des précautions particulières sur le plan de l'hygiène étant donné que les diamines encombrées (b) employées ne présentent pas les risques de toxicité qui sont attachés en général aux diamines biprimaires aromatiques non encombrées.

Il a maintenant été trouvé, et c'est ce qui constitue l'objet de la présente invention, que l'on peut apporter des propriétés particulières aux polymères décrits dans la demande française précitée par l'ajout, dans leur milieu de préparation, d'au moins un composé choisi dans le groupe constitué par : une résine époxy chlorée ou bromée ; un N,N'-alkylène-bis-tétrahalogénophtalimide ; et un produit contenant deux radicaux phényle reliés directement par un lien valentiel simple, un groupement divalent ou un atome, dans lequel chaque radical phényle est substitué par un radical (méth)allyloxy et par au moins deux atomes de chlore ou de brome ; cette mesure permet d'obtenir notamment une excellente résistance à la combustion et un faible coefficient d'expansion thermique pour les polymères qui sont ainsi préparés.

Plus précisément, la présente invention concerne des polymères à groupements imides qui comprennent le produit de réaction, à une température allant de 50°C à 300°C, entre :

- (a) un N,N'-bis-imide ou une association de plusieurs bis-imides répondant à la formule (I) et aux définitions données ci-avant ;
- (b) une ou plusieurs diamine(s) encombrée(s) répondant aux formules (II) et (III) et aux défintions données ci-avant ; et
- éventuellement (c) un ou plusieurs monomère(s) non halogéné(s) autre(s) qu'un bis-imide de formule (I) et comportant une ou plusieurs double(s) liaison(s) carbone-carbone polymérisable(s) ; et
- éventuellement encore (d) un composé de type imidazole, lesdits polymères à groupements imides étant caractérisés en ce que le milieu de réaction qui sert à les préparer contient en outre un additif (e) consistant dans au moins une résine époxy chlorée ou bromée (e1).

D'autres composés halogénés pourraient être utilisés en mélange du composé (e1) tels que :

* (e2) un N,N'-alkylène-bis-tétrahalogénophtalimide de formule :

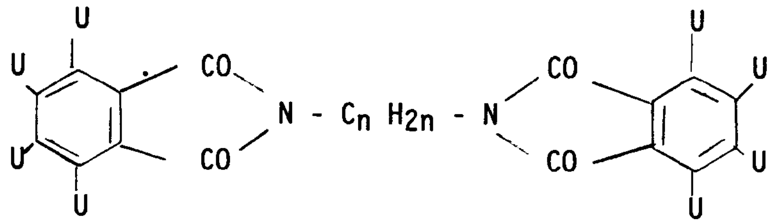 (IV)

dans laquelle:

. les symboles U, identiques ou différents, représentent chacun un atome de chlore ou de brome ;

. le radical alkylène $-C_n H_{2n}-$ peut être linéaire ou ramifié ;

. n est un nombre entier égal à 1, 2, 3 ou 4 ;

* et (e3) un produit halogéné de formule :

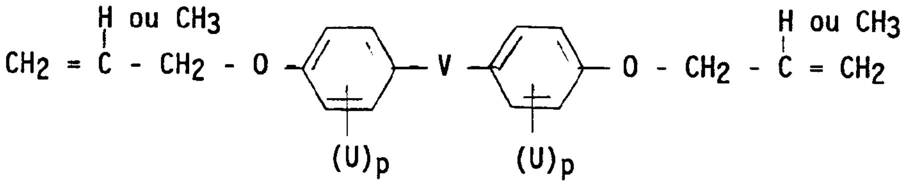 (V)

sans laquelle :

. les symboles U ont la signification donnée ci-avant ;

. le symbole V représente un lien valentiel simple, un radical alkylène $-C_n H_{2n}-$, linéaire ou ramifié, avec n étant égal à 1, 2, 3 ou 4 ou un atome d'oxygène ;

. p est un nombre entier égal à 2, 3 ou 4.

Par résine époxy chlorée ou bromée (e1), on entend définir une résine époxy qui possède un poids d'équivalent époxy compris entre 200 et 2000 et qui consiste dans un éther glycidique obtenu en faisant réagir avec de l'épichlorhydrine un dérivé chloré ou bromé sur le (ou les) noyau(x) aromatique(s) issu d'un polyphénol choisi dans le groupe formé par : la famille des bis(hydroxyphényl)alcanes comme le bis(hydroxy-4 phényl)-2,2 propane, le bis(hydroxy-4 phényl) méthane, le bis(hydroxy-4 phényl) méthyl phényl-méthane, les bis(hydroxy-4 phényl)tolyl-méthanes ; le résorcinol ; l'hydroquinone ; le pyrocatéchol ; le dihydroxy-4,4' diphényle ; et les produits de condensation des phénols précités avec un aldéhyde.

L'expression "poids d'équivalent époxy", qui apparaît ci-avant, peut être définie comme étant le poids de résine (en gramme) renfermant une fonction époxy

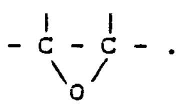

On choisit de préférence une résine époxy possédant un poids d'équivalent époxy compris entre 250 et 500. Quant aux caractéristiques physiques de cette résine, elles vont de celles des résines liquides de faible viscosité (environ $2.10^{-3}$ Pa.s à 25°C) jusqu'à celles de résines pâteuses dont le point de fusion est de l'ordre de 60°C.

On utilise tout préférentiellement dans la présente invention une résine époxy (e1) consistant dans une résine appartenant à la famille des éthers glycidiques des bis(hydroxyphényl)alcanes, bromés sur les noyaux aromatiques, dont on a parlé ci-avant à propos de la définition détaillée de la résine (e1).

Par résine époxy chlorée ou bromée (e1), on entend définir aussi des mélanges d'une résine époxy chlorée ou bromée du type de celles dont on a parlé ci-avant avec une résine époxy de même nature mais non halogénée qui possède un poids d'équivalent époxy compris entre 100 et 1000 et qui consiste dans un éther glycidique obtenu en faisant réagir avec de l'épichlorhydrine un polyphénol non chloré ou non bromé sur le (ou les) noyau(x) aromatique(s) choisi dans le groupe des phénols dont on a parlé ci-avant. Quand on utilise de pareils mélanges, on choisit de préférence une résine époxy non halogénée possédant un poids d'équivalent époxy compris entre 150 et 300 ; on choisit tout préférentiellement une résine époxy non halogénée consistant dans une résine appartenant à la famille des éthers glycidiques des bis(hydroxyphényl)alcanes, non halogénés sur les noyaux aromatiques, dont on a parlé ci-avant.

S'agissant du composé (e2) de formule (IV), on choisit de préférence un N,N'-alkylène-bis-tétrabromophtalimide. On utilise tout préférentiellement dans la présente invention le N,N'-éthylène-bis-tétrabromophtalimide.

S'agissant du composé (e3) de formule (V), on choisit de préférence un bis(allyloxydibromophényl)alcane de formule :

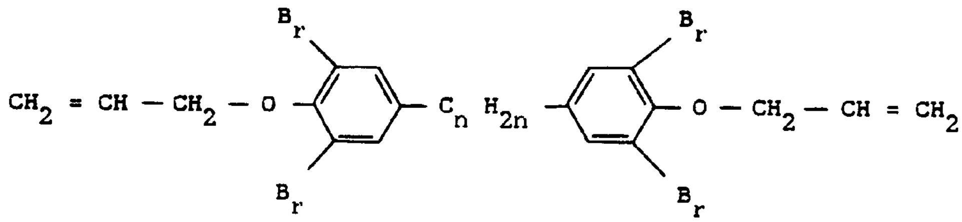

(VI)

dans laquelle n est un nombre entier égal à 1, 2 ou 3. On utilise tout préférentiellement dans la présente invention le bis(allyloxy-4 dibromo-3,5 phényl)-2,2 propane.

La quantité de l'additif (e) représente 2 % à 30 % et, de préférence, 3 % à 15 % du poids du mélange bis-imide(s) (a) + diamine(s) (b) + éventuellement réactif (c).

On a constaté que la quantité de chlore ou de brome apportée dans les polymères selon l'invention par l'additif (e) est de nature à influencer certaines propriétés des polymères durcis obtenus, notamment les propriétés en matière de stabilité thermique et celles en matière d'adhérence des polymères sur des métaux tels que par exemple le cuivre. Les meilleurs résultats sont obtenus lorsque cette quantité de chlore ou de brome apportée par l'additif (e), exprimée par le pourcentage en poids de chlore élémentaire ou de brome élémentaire par rapport au poids du mélange global bis-imide(s) (a) + diamine(s) (b) + réactif facultatif (c) + additif (e), représente au plus 6 % ; cette quantité de chlore ou de brome se situe de préférence dans l'intervalle allant de 1 à 5%. On peut ajuster aisément la quantité de chlore ou de brome à la valeur souhaitée en mettant en oeuvre par exemple des résines époxy (e1) ayant une teneur en chlore ou en brome plus ou moins importante et/ou en partant de mélanges de résines époxy chlorées ou bromées (e1) avec les composés (e2) et/ou (e3).

A titre d'exemples spécifiques de bis-imides (a) de formule (I) on peut citer en particulier les composés indiqués dans la demande française FR-A-2.608.613, c'est-à-dire :

- le N,N'-métaphénylène-bis-maléimide,
- le N,N'-paraphénylène-bis-maléimide,
- le N,N'-4,4'-diphénylméthane-bis-maléimide,
- le N,N'-4,4'-diphényléther-bis-maléimide,
- le N,N'-4,4'-diphénylsulphone-bis-maléimide,
- le N,N'-cyclohexylène-1,4-bis-maléimide,
- le N,N'-4,4'-diphényl-1,1 cyclohexane-bis-maléimide,
- le N,N'-4,4'-diphényl-2,2 propane-bis-maléimide,
- le N,N'-4,4'-triphénylméthane-bis-maléimide,
- le N,N'-méthyl-2 phénylène-1,3-bis-maléimide,
- le N,N'-méthyl-4 phénylène-1,3-bis-maléimide,
- le N,N'-méthyl-5 phénylène-1,3-bis-maléimide.

Ces bis-maléimides peuvent être préparés selon les procédés décrits dans le brevet américain US-A-3.018.290 et le brevet anglais GB-A-1.137.290. On utilise de préférence pour la mise en oeuvre de la présente invention, le N,N'-4,4'-diphénylméthane-bis-maléimide pris seul ou en mélange avec le N,N'-méthyl-2 phénylène-1,3-bis-maléimide, le N,N'-méthyl-4 phénylène-1,3-bis-maléimide et/ou le N,N'-méthyl-5 phénylène-1,3-bis-maléimide.

A titre d'exemples spécifiques de diamines encombrées de formules (II) et (III), on peut citer en particulier :

- le diamino-4,4' tétraméthyl-3,3',5,5' diphénylméthane,
- le diamino-4,4' tétraéthyl-3,3',5,5' diphénylméthane,
- le diamino-4,4' diméthyl-3,5 diéthyl-3',5' diphénylméthane,
- le diamino-4,4' diéthyl-3,3',diméthyl-5,5' diphénylméthane,
- le diamino-4,4' tétraisopropyl-3,3',5,5' diphénylméthane,
- le diamino-4,4' diisopropyl-3,3' diméthyl-5,5' diphénylméthane,
- le diamino-1,3 diéthyl-2,4 méthyl-6 benzène,
- le diamino-1,3 méthyl-2 diéthyl-4,6 benzène,
- et leurs mélanges.

Ces diamines encombrées peuvent être préparées selon les procédés décrits dans le brevet anglais GB-A-852.651 et le brevet américain US-A-3.481.900. On utilise de préférence, pour la mise en oeuvre de la présente invention, le diamino-4,4′ tétraméthyl-3,3′5,5′ diphénylméthane, le diamino-4,4′ tétraéthyl-3,3′5,5′ diphénylméthane, le diamino-4,4′ diéthyl-3,3′ diméthyl-5,5′ diphénylméthane et leurs mélanges.

Les quantités de N′,N-bis-imide(s) (a) et de diamine(s) encombrée(s) (b) sont choisies de façon à ce que le rapport r :

$$\frac{\text{nombre de moles de bis – imide (s) (a)}}{\text{nombre de moles de diamine(s) (b)}}$$

se situe dans l'intervalle allant de 1,1/l à 20/l et, de préférence, allant de 2/l à 5/l.

Il peut être avantageux dans certains cas de modifier les polymères selon la présente invention par emploi supplémentaire d'un réactif copolymérisable (c) et/ou d'un composé de type imidazole (d).

Comme réactif facultatif (c) qui convient bien, on peut citer en particulier les composés indiquée dans la demande française FR-A-2.608.613, à savoir :

(c1) soit un ou plusieurs monomères de formule :

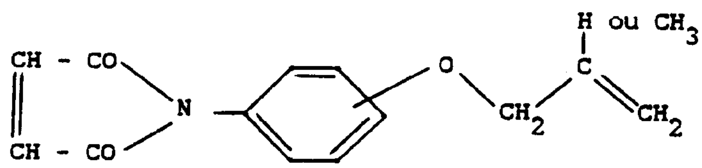

(VII)

dans laquelle le radical allyloxy ou méthallyloxy est en position ortho, métha ou par par rapport à l'atome de carbone du cycle benzénique relié à l'azote ;

(c2) soit un composé comprenant :

- un mélange d'un monomère de formule :

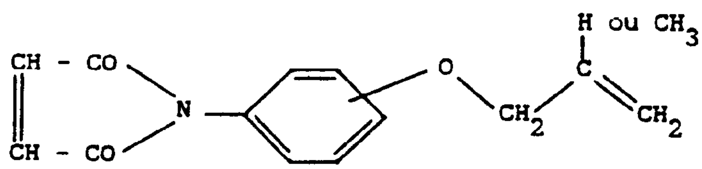

(VII)

dans laquelle le radical allyloxy ou méthallyloxy est en position ortho, métha ou para par rapport à l'atome de carbone du cycle benzénique relié à l'azote,

- avec:

. au moins un dérivé monosubstitué de formule :

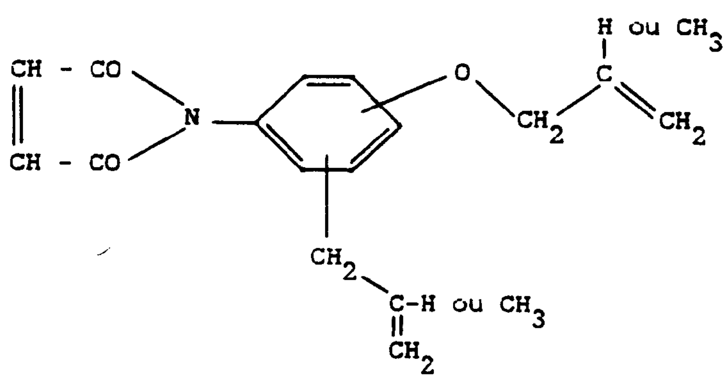

(VIII)

. et éventuellement un ou plusieurs dérivés disubstitués de formule :

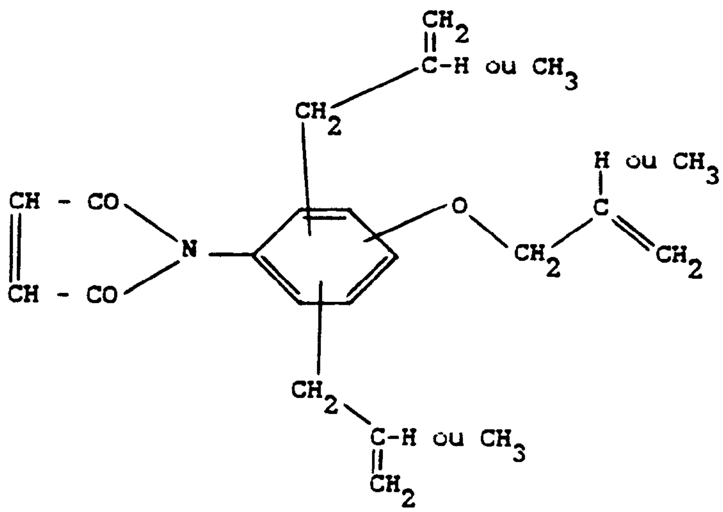

(IX)

Dans le composé précité servant de réactif (c2), les proportions des divers constituants du mélange des produits de formules (VII), (VIII) et éventuellement (IX) peuvent varier dans des larges limites. De manière générale, les proportions des constituants sont choisies entre les limites suivantes (exprimant le pourcentage pondéral de chacun des constituants dans le mélange) :

- au moins 30 %, et de préférence de 50 % à 80 % de N-(méth)allyloxyphénylmaléimide de formule (VII),
- de 5 % à 50 % et de préférence de 10 % à 35 % de dérivé(s) mono-(méth)allyl substitué(s) de formule (VIII),
- et de 0 % à 20 % et de préférence de 0 % à 15 % de dérivé(s) di-(méth)allyl substitué(s) de formule (IX),

la somme des constituants devant dans chaque cas être égale à 100 % en poids.

(c3) soit un ou plusieurs hétérocycles substitués.

Il doit être entendu que l'on peut utiliser, comme réactif (c), des mélanges (c1 + c3) ou (c2 + c3).

S'agissant du réactif facultatif (c1), il est choisi parmi :

- le N-(allyloxy-2 phényl)maléimide,
- le N-(allyloxy-3 phényl)maléimide,
- le N-(allyloxy-4 phényl)maléimide,
- le N-(méthallyloxy-2 phényl)maléimide,
- le N-(méthallyloxy-3 phényl)maléimide,
- le N-(méthallyloxy-4 phényl)maléimide,
- et leurs mélanges.

Les maléimides de formule (VII) sont des produits connus qui sont décrits dans la demande de brevet européen EP-A-0.208.634.

S'agissant du réactif facultatif (c2), on utilise de préférence comme composé comprenant un mélange de N-(méth)allyloxyphénylmaléimide de formule (VII) avec un ou plusieurs dérivé(s) de substitution (méth)allylé(s) de formule(s) (VIII) et éventuellement (IX), le produit brut obtenu par mise en oeuvre du procédé décrit dans la demande de brevet européen EP-A-0.274.967.

S'agissant du réactif facultatif (c3), il est choisi parmi : les vinylpyridines, la N-vinylpyrrolidone, l'isocyanurate d'allyle, le vinyltétrahydrofuranne.

S'agissant de la quantité du réactif facultatif (c), elle représente généralement moins de 60 % et, de préférence, de 2 % à 25 % du poids total des réactifs (a) et (b).

Le composé imidazole (d) facultatif répond à la formule générale indiquée dans la demande française FR-A-2.608.613 ; c'est-à-dire :

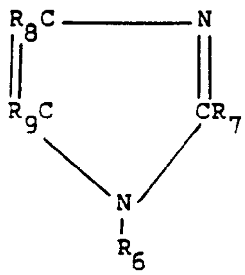

(X)

dans laquelle $R_6$, $R_7$, $R_8$ et $R_9$, identiques ou différents, représentent chacun : un atome d'hydrogène, un radical alkyle ou alcoxy ayant de 1 à 20 atomes de carbone, vinyle, phényle, nitro, $R_8$ pouvant former avec $R_9$ et les atomes de carbone auxquels sont liés ces radicaux un cycle unique comme par exemple un cycle benzénique, $R_6$ pouvant également représenter un groupement carbonyle lié à un deuxième cycle imidazole.

Comme exemples spécifiques de composés imidazole (d), on peut citer en particulier : l'imidazole ou glyoxaline, le méthyl-1 imidazole, le méthyl-2 imidazole, le diméthyl-1,2 imidazole, le vinyl-1 imidazole, le vinyl-1 méthyl-2 imidazole, le benzimidazole, le carbonyldiimidazole.

Le composé imidazole facultatif (d) est utilisé en quantités catalytiques. Selon la nature du composé imidazole et selon la vitesse de polymérisation souhaitée au stade de la mise en oeuvre, on utilise le composé imidazole à un taux se situant dans l'intervalle allant de 0,005 à 1 % en poids par rapport à l'ensemble des réactifs (a) + (b) + éventuellement (c) et, de préférence, allant de 0,01 à 0,5 %.

Les polymères selon l'invention peuvent être préparés par chauffage direct du ou des bis-imide(s) (a), du réactif aminé (b) et de l'additif (e), en présence éventuellement du réactif (c) et/ou du composé imidazole (d), au moins jusqu'à l'obtention d'un mélange liquide homogène. La température peut varier en fonction de l'état physique des composés en présence mais elle se situe généralement entre 50°C et 300°C. Il est avantageux d'amener et de maintenir les composés de départ dans un état de mélange intime avant et pendant le chauffage à l'aide par exemple d'une bonne agitation. Quand on utilise le réactif (c) et/ou le composé imidazole (d), il(s) est(sont) de préférence ajouté(s) dans le mélange réactionnel bien agité après avoir réalisé la fusion du mélange (a) + (b) + (e). Lorsque le composé (d) est particulièrement actif, pour éviter son encapsulation dans le réseau polymère engendré, il est souhaitable de l'ajouter dans un solvant ou diluant compatible avec le milieu réactionnel ; on a trouvé qu'il pouvait être intéressant d'utiliser comme solvant ou diluant un des liquides organiques polaires dont on parle ci-après.

La préparation des polymères selon l'invention peut aussi être effectuée par chauffage du mélange des réactifs en présence de quantités variables d'un diluant organique qui est liquide dans une partie au moins de l'intervalle 50°C-250°C. Parmi ces diluants, on peut mentionner en particulier des hydrocarbures aromatiques comme les xylènes et le toluène, les hydrocarbures halogénés comme les chlorobenzènes, des liquides organiques polaires comme le dioxanne, le tétrahydrofuranne, l'oxyde de dibutyle, le diméthylformamide, le diméthylsulfoxyde, la O-méthylpyrrolidone, le diméthylacétamide, la cyclohexanone, le méthylglycol et la méthyléthyl-cétone. Les solutions ou suspensions de polymères peuvent être utilisées telles quelles pour de nombreux emplois ; on peut également isoler les polymères, par exemple par filtration, éventuellement après précipitation au moyen d'un diluant organique miscible avec le solvant utilisé.

Il doit être compris que les propriétés des polymères selon l'invention peuvent varier dans une large mesure en fonction notamment de la nature exacte des réactifs engagés, des proportions de réactifs choisies et des conditions précises de température adoptées dans l'intervalle précédemment mentionné. En ce qui concerne les polymères obtenus, ceux-ci peuvent être des polymères durcis, insolubles dans les solvants usuels tels que par exemple les liquides organiques polaires cités dans le paragraphe précédent et ne présentant pas de ramollissement notable au-dessous de la température à laquelle ils commencent à se dégrader.

Mais ces polymères peuvent également se présenter sous l'aspect de prépolymères (P) solubles dans les solvants usuels tels que par exemple les liquides organiques polaires cités ci-avant et présentant un point de ramollissement à une température inférieure à 200°C [en général ce point de ramollissement est compris entre 50° et 150°C]. Ces prépolymères peuvent être obtenus en masse en chauffant le mélange des réactifs jusqu'à l'obtention d'un produit homogène ou pâteux à une température généralement située entre 50° et 180°C pendant une durée qui peut aller de quelques minutes à quelques heures, cette durée étant d'autant plus brève que la température adoptée est plus élevée. Avant de soumettre le mélange des réactifs au chauffage, il est avantageux là aussi d'en effectuer par agitation un mélange intime préalable. Il existe là aussi une méthode préférée de mise en oeuvre du réactif (c) et/ou du composé imidazole (d) facultatif et il s'agit de celle indiquée ci-avant à propos de la préparation directe de polymères durcis. La préparation des polymères peut également être effectuée en présence de quantités variables d'un diluant qui est liquide dans une partie au moins de l'in-

tervalle 50°-180°C. Dans ce contexte, on peut avantageusement utiliser comme diluant les liquides organiques polaires dont on a parlé ci-avant.

Les prépolymères (P) peuvent être utilisés à l'état de masse liquide, une simple coulée à chaud suffisant pour la mise en forme et la réalisation d'objets moulés. On peut aussi, après refroidissement et broyage, les utiliser sous la forme de poudres qui se prêtent remarquablement aux opérations de moulage par compression, éventuellement en présence de charges à l'état de poudres, de sphères, de granules, de fibres ou de paillettes. Sous la forme de suspensions ou de solutions, les prépolymères (P) peuvent être utilisés pour la réalisation de revêtements et d'articles intermédiaires préimprégnés dont l'armature peut être constituée par des matières fibreuses à base de silicate ou d'oxyde d'aluminium ou de zirconium, de carbone, de graphite, de bore, d'amiante ou de verre. On peut encore utiliser ces prépolymères (P) pour la réalisation de matériaux cellulaires après incorporation d'un agent porogène tel que par exemple l'azodicarbonamide.

Dans un second stade, les prépolymères (P) peuvent être durcis par chauffage jusqu'à des températures de l'ordre de 300°C, généralement comprises entre 150° et 300°C ; une mise en forme complémentaire peut être effectuée pendant le durcissement, éventuellement sous vide ou sous une pression super-atmosphérique, ces opérations pouvant également être consécutives.

Conformément à un mode de réalisation préféré de la présente invention, on opère en deux stades, le premier stade consistant à chauffer le mélange des réactifs entre 50° et 180°C pour former un prépolymère (P), le second stade consistant à durcir le prépolymère (P), après lui avoir donné la forme désirée, par chauffage jusqu'à des températures de l'ordre de 300°C, généralement comprises entre 150°C et 300°C.

Conformément à un autre mode de réalisation préféré de la présente invention, on opère en deux stades, mais en utilisant dans le premier stade un procédé de préparation en continu du prépolymère (P) consistant à introduire isolément dans un malaxeur à vis extrudeuse :

- d'une part le bis-imide (a) à l'état solide divisé, et
- d'autre part le groupe des réactifs constitué par le réactif aminé (b) à l'état solide, liquide ou fondu et l'additif (e) à l'état liquide, avec au besoin le réactif (c) à l'état liquide et/ou le composé imidazole (d) à l'état solide ou en solution, les différents réactifs de ce groupe pouvant eux-mêmes être introduits de leur côté ensemble ou séparément.

Par l'expression "malaxeur à vis extrudeuse", on entend désigner un appareil qui ne présente pas de zone morte lors de la progression de la matière. Des appareils de ce genre qui peuvent comporter une ou plusieurs vis sont décrits dans l'ouvrage de E.G. FISHER-Extrusion of Plastics (Interscience Publisher 1964) pages 104 à 108. Ces malaxeurs peuvent comporter deux vis sans fin s'engrenant intimement l'une dans l'autre et tournant dans le même sens ; un appareil de ce type équipé plus particulièrement pour la préparation de téréphtalates alcalins est décrit dans le brevet français FR-A-1.462.935. Une autre variété de malaxeurs utilisables est constitués par les appareils comportant une vis sans fin à filetage interrompu effectuant simultanément un mouvement de rotation et un mouvement oscillatoire dans la direction de l'axe, logée dans une enveloppe comportant des dents qui coopèrent avec les ailettes interrompues de la vis. Des appareils de ce type sont décrits dans les brevets français FR-A-1.184.392, 1.184.393, 1.307.106 et 1.369.283.

Les polymères selon l'invention intéressent les domaines de l'industrie qui requièrent des matériaux doués de bonnes propriétés mécaniques et électriques ainsi que d'une grande inertie chimique à des températures de 200° à 300°C. A titre d'exemples, ils conviennent pour la fabrication d'isolants en plaques ou tubulaires pour transformateurs électriques, de supports de circuits imprimés, etc... Les articles préimprégnés sont utilisables pour la réalisation des pièces ayant des formes et des fonctions variées dans de nombreuses industries comme par exemple dans les industries électriques et électroniques. Ces pièces, appelées statifiés, qui peuvent être des pièces de révolution sont obtenues par placage de plusieurs couches de préimprégnés sur une forme ou un support. On peut utiliser aussi les préimprégnés comme renforts ou comme moyen de réparation de pièces détériorées.

Les exemples suivants sont donnés à titre illustratif mais non limitatif.

EXEMPLE :

Dans un réacteur en verre muni d'un agitateur de type ancre, on introduit à température ambiante :

- 82 g (0,239 mole) de N,N'-4,4'-diphénylméthane-bis-maléimide, et
- 18 g (0,070 mole) de diamino-4,4' tétraméthyl-3,3',5,5' diphénylméthane, et
- 8 g d'une résine époxy bromée résultant de la condensation de bisphénol A tétrabromé et d'épichlorhydrine ; elle possède un taux de brome élementaire de l'ordre de 50 % en poids et un poids d'équivalent époxy de 450 ; elle est disponible dans le commerce sous la marque déposée QATREX de la Société DOW, type 6410 ; la quantité de brome apportée par la résine époxy, exprimés par le pourcentage en poids de brome élémentaire par rapport au poids de l'ensemble bis-imide + diamine + résine époxy + N-vinylpyrro-

lidone-2 (cf. ci-après), est égale à 3,4 %. Cette résine est introduite dans le réacteur sous forme de solution dans 10 g de cyclohexanone.

On plonge le réacteur dans un bain d'huile préchauffé à 160°C et le mélange est agité jusqu'à fusion complète des ingrédients engagés et obtention d'une masse homogène. La durée de cette étape est de 5 minutes. Le mélange fondu ainsi obtenu est refroidi jusqu'à 140°C et on introduit 8 g de N-vinylpyrrolidone-2, puis on laisse réagir l'ensemble sous agitation pendant 28 minutes.

On obtient ainsi un prépolymère présentant un point de ramollissement voisin de 80°C. On appelle point de ramollissement, la température approximative à laquelle une baguette de verre de 6 mm de diamètre peut s'enfoncer facilement de quelques millimètres dans le prépolymère. Ce prépolymère est soluble dans des solvants comme par exemple la N-méthylpyrrolidone, le diméthylformamide et la cyclohexanone.

Avec un premier lot de prépolymère préparé comme indiqué ci-avant, on confectionne des préimprégnés et des stratifiés cuivrés à 10 plis (10 couches de préimprégnés). Dans cette optique, on utilise une solution de prépolymère à 50 % en poids dans la N-méthylpyrrolidone pour enduire un tissu de verre fabriqué par la Société PORCHER sous la référence 7628 dont le grammage est de 200 g/m$^2$ et ayant subi un traitement par du gamma-aminopropyltriéthoxysilane (silane A 1100 d'UNION CARBIDE). Le tissu imprégné contient 40 g de prépolymère pour 60 g de tissu ; on le sèche en atmosphère ventilée à 160°C pendant 5 minutes. On découpe ensuite 10 carrés (15 x 15 cm) que l'on empile avec une feuille de cuivre de 35 μm d'épaisseur placée sur l'une des faces extérieures de l'empilement et on place l'ensemble entre les plateaux d'une presse dans les conditions suivantes :

- pression : 40.10$^5$ Pa,
- chauffage des plateaux de la presse : 1 heure à 180°C.

Après une post-cuisson à 200°C pendant 16 heures, on examine l'adhérence du cuivre sur le stratifié à 10 plis préparé : cette adhérence, mesurée au dynamomètre par traction du cuivre à 90° d'angle (selon la norme MIL p 55 617 B avec une vitesse de traction de 55 mm/min), est de l'ordre de 19,6 N/cm. Dans les mêmes conditions, le stratifié cuivré à 10 plis confectionné à partir d'un prépolymère préparé comme indiqué ci-avant mais en absence de résine époxy bromée, conduit à une adhérence de l'ordre de 18,6 N/cm.

Avec un second lot de prépolymère, on prépare des préimprégnés à 45 % en poids de prépolymère et des stratifiés comportant 5 plis dans les conditions décrites ci-avant (à noter qu'aucune feuille de cuivre n'est utilisée ici). Après une post-cuisson à 200°C pendant 16 heures, on effectue des mesures de combustibilité à l'aide du test UL 94 vertical (épaisseur des éprouvettes à base de stratifié : 0,8 mm ; le taux de résine dans le stratifié après post-cuisson est d'environ 40 % en poids ; le temps de combustion est donné en seconde après conditionnement de 48 heures, à 23°C et sous 50 % d'humidité relative ; le classement est établi sur la moyenne de 10 résultats : 5 éprouvettes et 2 tests sur chaque éprouvette) :

- temps de combustion : 3 s ;
- classement : VO

Le classement est trouvé égal à V1 en absence de résine époxy bromée.

Sur un troisième lot de prépolymère, on prépare des préimprégnés à 40 % en poids de prépolymère et des stratifiés comportant 22 plis dans les conditions décrites ci-avant (aucune feuille de cuivre n'est utilisée ici aussi). Après une post-cuisson de 200°C pendant 16 heures, on effectue des mesures de coefficient d'expansion thermique selon l'axe Z des stratifiés (épaisseur des éprouvettes à base de stratifié : 3 mm). Ces mesures sont réalisées par Analyse Thermomécanique (TMA), à l'aide d'un appareil DU PONT modèle 982, avec une vitesse de montée en température de 10 K/min sous atmosphère d'azote. La valeur trouvée pour ce coefficient est de l'ordre de 30.10$^{-6}$ m.m$^{-1}$.K$^{-1}$. Dans les mêmes conditions, le stratifié à 22 plis confectionné à partir d'un prépolymère préparé en absence de résine époxy bromée présente un coefficient d'expansion thermique selon l'axe Z de l'ordre de 40.10$^{-6}$ m.m$^{-1}$.K$^{-1}$. Par ailleurs, la température de transition vitreuse du polymère durci, qui a été évaluée lors des mesures effectuées par Analyse Thermomécanique, est trouvée égale à 250°C.

## Revendications

### Revendications pour les Etats contractants suivants : BE, CH, DE, FR, GB, IT, LI, NL, SE

**1.** Polymères à groupements imides caractérisés en ce qu'ils comprennent le produit de réaction, à une température allant de 50°C à 300°C, entre :

- (a) un N,N'-bis-imide ou une association de plusieurs bis-imides de formule :

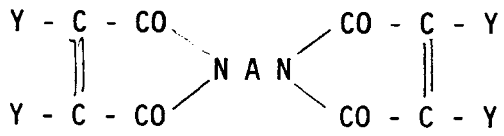

(I)

dans laquelle :

. les symboles Y, identiques ou différents, représentent chacun H, $CH_3$ ou Cl ;

. le symbole A représente un radical divalent choisi dans le groupe constitué par les radicaux : cyclohexylènes ; phénylènes ; méthyl-4 phénylène-1,3 ; méthyl-2 phénylène-1,3 ; méthyl-5 phénylène-1,3 ; diéthyl-2,5 méthyl-3 phénylène-1,4 ; et les radicaux de formule :

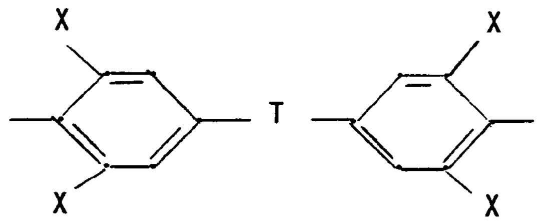

dans laquelle T représente un lien valentiel simple ou un groupement :

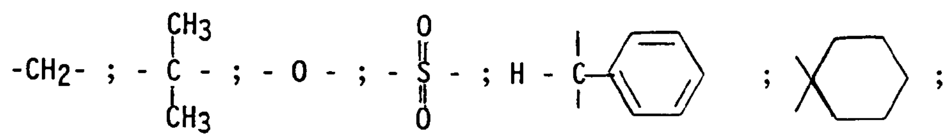

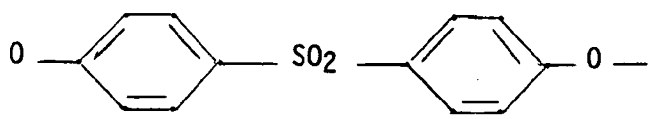

et les symboles X, identiques ou différents, représentent chacun un atome d'hydrogène, un radical méthyle, éthyle ou isopropyle ;

- (b) une ou plusieurs diamine(s) biprimaire(s) encombrée(s) prise(s) dans le groupe formé par :

(i) les espèces répondant à la formule générale :

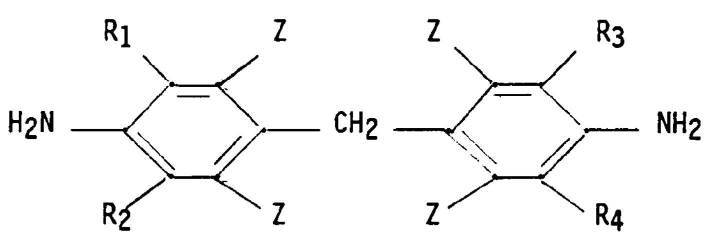

(II)

dans laquelle :

. les symboles $R_1$, $R_2$, $R_3$ et $R_4$, identiques ou différents, représentent chacun un radical méthyle, éthyle, propyle ou isopropyle ;

. les symboles Z, identiques ou différents, représentent chacun un atome d'hydogène ou un atome de chlore ;

. (2i) et les espèces répondant à la formule générale :

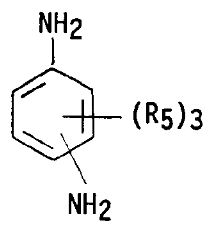

(III)

dans laquelle :

. les radicaux amino sont en position méta ou para, l'un par rapport à l'autre ;

. les symboles $R_5$, identiques ou différents, représentent chacun un radical méthyle, éthyle, propyle ou isopropyle ;

- (c) éventuellement un ou plusieurs monomère(s) non halogéné(s) autre(s) qu'un bis-imide de formule (I) et comprenant une ou plusieurs double(s) liaison(s) carbone-carbone polymérisable(s) ;
- (d) éventuellement un composé de type imidazole ; et avec des quantités de composés (a) et de composés (b) choisies de façon à obtenir un rapport r :

$$\frac{\text{nombres de moles de bis–imides (a)}}{\text{nombre de moles de diamines (b)}}$$

situé dans l'intervalle allant de 1,1/l à 20/l ;

lesdits polymères à groupements imides étant caractérisés en ce que le milieu de réaction qui sert à les préparer contient en outre un additif (e) constitué par au moins une résine époxy chlorée ou bromée (e1) eventuellement en mélange avec une résine époxy non halogénée, eventuellement au moins un N,N'-alkyléne-bis-tétrahalogénophtalimide (e2) de formule :

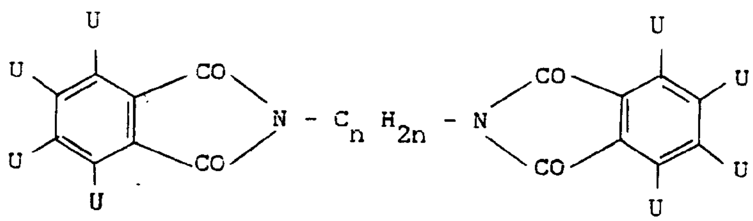

(IV)

dans laquelle :

. les symboles U, identiques ou différents, représentent chacun un atome de chlore ou de brome ;

. le radical alkylène $-C_n H_{2n}-$ peut être linéaire ou ramifié ;

. n est un nombre entier égal à 1, 2, 3 ou 4 ;

et eventuellement au moins un produit halogéné (e3) de formule :

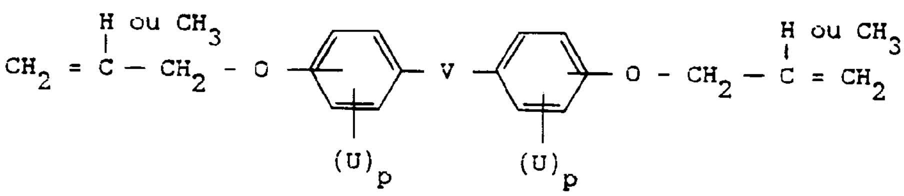

(V)

dans laquelle :

. les symboles U ont la signification donnée ci-avant ;

. le symbole V représente un lien valentiel simple, un radical alkylène $-C_n H_{2n}-$, linéaire ou ramifié, avec n étant égal à 1, 2, 3 ou 4 ou un atome d'oxygène ;

. p est un nombre entier égal à 2, 3 ou 4 et en ce que la quantité de composé (e) représente 2 à 30 % du poids du mélange bis-imides (a) + diamine(s) (b) + éventuellement réactif (c).

**2.** Polymères selon la revendication 1, caractérisés en ce que le réactif (a) est pris dans le groupe formé par :

- le N,N'-métaphénylène-bis-maléimide,
- le N,N'-paraphénylène-bis-maléimide,

- le N,N′-4,4′-diphénylméthane-bis-maléimide,
- le N,N′-4,4′-diphényléther-bis-maléimide,
- le N,N′-4,4′-diphénylsulphone-bis-maléimide,
- le N,N′-cyclohexylène-1,4-bis-maléimide,
- le N,N′-4,4′-diphényl-1,1 cyclohexane-bis-maléimide,
- le N,N′-4,4′-diphényl-2,2 propane-bis-maléimide,
- le N,N′-4,4′-triphénylméthane-bis-maléimide,
- le N,N′-méthyl-2 phénylène-1,3-bis-maléimide,
- le N,N′-méthyl-4 phénylène-1,3-bis-maléimide,
- le N,N′-méthyl-5 phénylène-1,3-bis-maléimide,
- leurs mélanges.

**3.** Polymères selon l'une quelconque des revendications 1 et 2, caractérisés en ce que le réactif (b) est pris dans le groupe formé par :
- le diamino-4,4′ tétraméthyl-3,3′,5,5′ diphénylméthane,
- le diamino-4,4′ tétraéthyl-3,3′,5,5′ diphénylméthane,
- le diamino-4,4′ diméthyl-3,5 diéthyl-3′,5′ diphénylméthane,
- le diamino-4,4′ diéthyl-3,3′ diméthyl-5,5′ diphénylméthane,
- le diamino-4,4′ tétraisopropyl-3,3′,5,5′ diphénylméthane,
- le diamino-4,4′ diisopropyl-3,3′ diméthyl-5,5′ diphénylméthane,
- le diamino-1,3 diéthyl-2,4 méthyl-6 benzène,
- le diamino-1,3 méthyl-2 diéthyl-4,6 benzène,
- et leurs mélanges.

**4.** Polymères selon l'une quelconque des revendications 1 à 3, caractérisés en ce que l'additif (e1) consiste dans au moins un composé choisi dans le groupe formé par :
∗ (e1) : (i) une résine époxy chlorée ou bromée qui possède un poids d'équivalent époxy compris entre 200 et 2000 et qui consiste dans un éther glycidique obtenu en faisant réagir avec de l'épichlorhydrine un dérivé chloré ou bromé sur le (ou les) noyau(x) aromatique(s) issu d'un polyphénol choisi dans le groupe formé par : la famille des bis(hydroxyphényl)alcanes comme le bis(hydroxy-4 phényl)-2,2 propane, le bis(hydroxy-4 phényl) méthane, le bis(hydroxy-4 phényl) méthyl-phényl-méthane, les bis(hydroxy-4 phényl)tolyl-méthanes ; le résorcinol ; l'hydroquinone ; le pyrocatéchol ; le dihydroxy-4,4′diphényle ; et les produits de condensation des phénols précités avec un aldéhyde ; ou (2i) un mélange d'une pareille résine époxy chlorée ou bromée avec une résine époxy de même nature, mais non halogénée ;

**5.** Polymères selon l'une quelconque des revendications 1 à 4, caractérisés en ce que le réactif facultatif (c), quand il est utilisé, est employé en quantités représentant moins de 60 % du poids total des réactifs (a) + (b).

**6.** Polymères selon l'une quelconque des revendications 1 à 5, caractérisés en ce que le composé imidazole facultatif (d), quand il est utilisé, est employé en quantités se situant dans l'intervalle allant de 0,005 à 1 % en poids par rapport à l'ensemble des réactifs (a) + (b) + éventuellement (c).

**7.** Polymères selon l'une quelconque des revendications 1 à 6, caractérisés en ce que la quantité de chlore ou de brome apportée par l'additif (e), exprimée par le pourcentage en poids de chlore élémentaire ou de brome élémentaire par rapport au poids du mélange global bis-imide(s) (a) + diamine(s) (b) + réactif facultatif (c) + additif (e), représente au plus 6 %.

**8.** Polymères selon l'une quelconque des revendications 1 à 7, caractérisés en ce qu'ils se trouvent sous forme de polymères durcis, insolubles dans les solvants organiques polaires usuels et ne présentant pas de ramollissement notable au-dessous de la température à laquelle ils commencent à se dégrader.

**9.** Polymères selon l'une quelconque des revendications 1 à 7, caractérisés en ce qu'ils se trouvent sous forme de prépolymères thermodurcissables (P) solubles dans les solvants organiques polaires usuels et présentent un point de ramollissement à une température inférieure à 200°C.

**Revendications pour l'Etat contractant suivant : ES**

1. Procédé de préparation de polymères à groupements imides se trouvant sous forme de polymères durcis, insolubles dans les solvants organiques polaires usuels et ne présentant pas de ramollissement notable au-dessous de la température à laquelle ils commencent à se dégrader, qui consiste à chauffer directement à une température comprise entre 50°C et 300°C le mélange des ingrédients suivants :
   - (a) un N,N'-bis-imide ou une association de plusieurs bis-imides de formule :

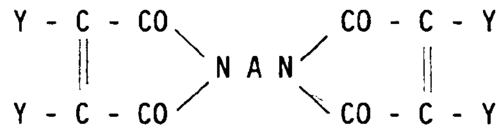

(I)

dans laquelle :

. les symboles Y, identiques ou différents, représentent chacun H, $CH_3$ ou Cl ;

. le symbole A représente un radical divalent choisi dans le groupe constitué par les radicaux : cyclohexylènes ; phénylènes ; méthyl-4 phénylène-1,3 ; méthyl-2 phénylène-1,3 ; méthyl-5 phénylène-1,3 ; diéthyl-2,5 méthyl-3 phénylène-1,4 ; et les radicaux de formule :

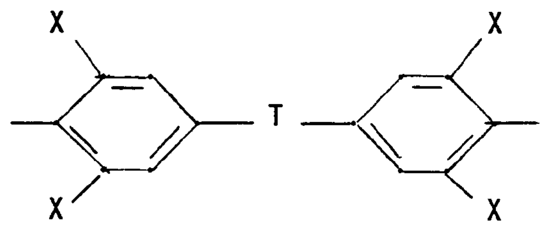

dans laquelle T représente un lien valentiel simple ou un groupement :

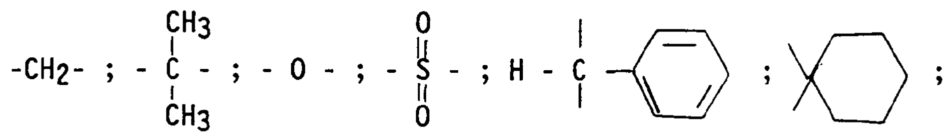

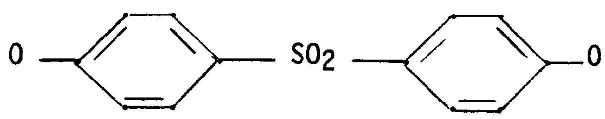

et les symboles X, identiques ou différents, représentent chacun un atome d'hydrogène, un radical méthyle, éthyle ou isopropyle ;

   - (b) une ou plusieurs diamine(s) biprimaire(s) encombrée(s) prise(s) dans le groupe formé par :

(i) les espèces répondant à la formule générale :

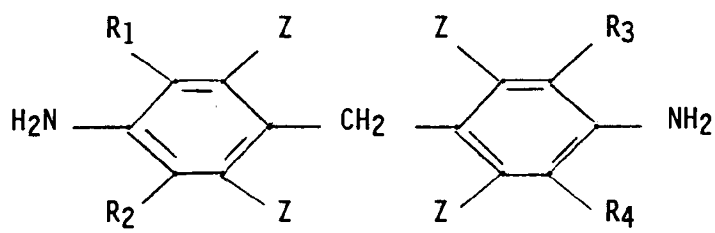

(II)

dans laquelle :

. les symboles $R_1$, $R_2$, $R_3$ et $R_4$, identiques ou différents, représentent chacun un radical méthyle, éthyle, propyle ou isopropyle ;

. les symboles Z, identiques ou différents, représentent chacun un atome d'hydogène ou un atome de chlore ;

(2i) et les espèces répondant à la formule générale :

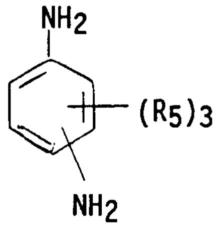

(III)

dans laquelle :

. les radicaux amino sont en position méta ou para, l'un par rapport à l'autre ;

. les symboles $R_5$, identiques ou différents, représentent chacun un radical méthyle, éthyle, propyle ou isopropyle ;

- (c) éventuellement un ou plusieurs monomère(s) non halogéné(s) autre(s) qu'un bis-imide de formule (I) et comprenant une ou plusieurs double(s) liaison(s) carbone-carbone polymérisable(s) ;
- (d) éventuellement un composé de type imidazole ; et avec des quantités de composés (a) et de composés (b) choisies de façon à obtenir un rapport r :

$$\frac{\text{nombres de moles de bis–imides (a)}}{\text{nombre de moles de diamines (b)}}$$

situé dans l'intervalle allant de 1,1/l à 20/l ;

ledit procédé étant caractérisé en ce que le milieu de réaction contient en outre un additif (e) constitué par au moins une résine époxy chlorée ou bromée (e1) eventuellement en mélange avec une résine époxy non halogénée, eventuellement au moins un N,N'-alkylène-bis-tétrahalogénophtalimide (e2) de formule :

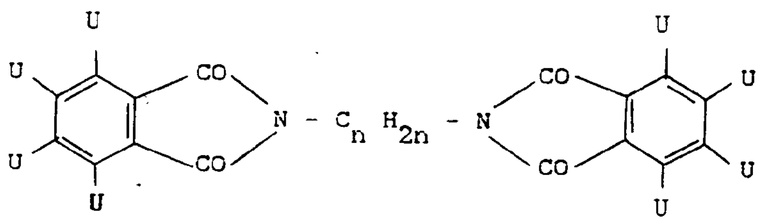

(IV)

dans laquelle :

- les symboles U, identiques ou différents, représentent chacun un atome de chlore ou de brome ;
- le radical alkylène $-C_n H_{2n}-$ peut être linéaire ou ramifié ;
- n est le nombre entier égal à 1, 2, 3 ou 4 ;

eventuellement au moins un produit halogéné (e3) de formule :

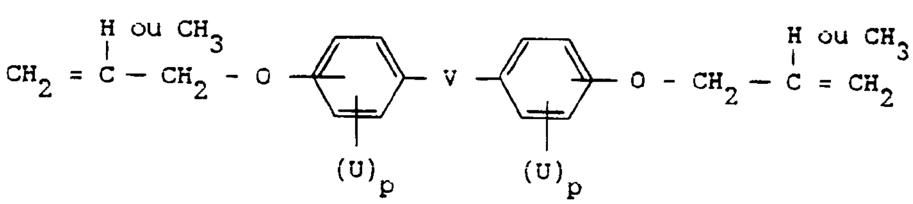

(V)

dans laquelle :

- les symboles U ont la signification donnée ci-avant ;
- le symbole V représente un lien valentiel simple, un radical alkylène $-C_n H_{2n}-$, linéaire ou ramifié, avec n étant égal à 1, 2, 3 ou 4 ou un atome d'oxygène ;

- p est un nombre entier égal à 2, 3 ou 4 et en ce que la quantité de composé (e) représente 2 à 30 % du poids du mélange bis-imides (a) + diamine(s) (b) + éventuellement réactif (c).

2. Procédé selon la revendication 1, caractérisés en ce que le réactif (a) est pris dans le groupe formé par :
   - le N,N'-métaphénylène-bis-maléimide,
   - le N,N'-paraphénylène-bis-maléimide,
   - le N,N'-4,4'-diphénylméthane-bis-maléimide,
   - le N,N'-4,4'-diphényléther-bis-maléimide,
   - le N,N'-4,4'-diphénylsulphone-bis-maléimide,
   - le N,N'-cyclohexylène-1,4-bis-maléimide,
   - le N,N'-4,4'-diphényl-1,1 cyclohexane-bis-maléimide,
   - le N,N'-4,4'-diphényl-2,2 propane-bis-maléimide,
   - le N,N'-4,4'-triphénylméthane-bis-maléimide,
   - le N,N'-méthyl-2 phénylène-1,3-bis-maléimide,
   - le N,N'-méthyl-4 phénylène-1,3-bis-maléimide,
   - le N,N'-méthyl-5 phénylène-1,3-bis-maléimide,
   - leurs mélanges.

3. Procédé selon l'une quelconque des revendications 1 et 2, caractérisé en ce que le réactif (b) est pris dans le groupe formé par :
   - le diamino-4,4' tétraméthyl-3,3',5,5' diphénylméthane,
   - le diamino-4,4' tétraéthyl-3,3',5,5' diphénylméthane,
   - le diamino-4,4' diméthyl-3,5 diéthyl-3',5' diphénylméthane,
   - le diamino-4,4' diéthyl-3,3' diméthyl-5,5' diphénylméthane,
   - le diamino-4,4' tétraisopropyl-3,3',5,5' diphénylméthane,
   - le diamino-4,4' diisopropyl-3,3' diméthyl-5,5' diphénylméthane,
   - le diamino-1,3 diéthyl-2,4 méthyl-6 benzène,
   - le diamino-1,3 méthyl-2 diéthyl-4,6 benzène,
   - et leurs mélanges.

4. Procédé selon l'une quelconque des revendications 1 à 3, caractérisé en ce que l'additif (e) consiste dans au moins un composé choisi dans le groupe formé par :
   * (e1) : (i) une résine époxy chlorée ou bromée qui possède un poids d'équivalent époxy compris entre 200 et 2000 et qui consiste dans un éther glycidique obtenu en faisant réagir avec de l'épichlorhydrine un dérivé chloré ou bromé sur le (ou les) noyau(x) aromatique(s) issu d'un polyphénol choisi dans le groupe formé par : la famille des bis(hydroxyphényl)alcanes comme le bis(hydroxy-4 phényl)-2,2 propane, le bis(hydroxy-4 phényl) méthane, le bis(hydroxy-4 phényl) méthyl-phényl-méthane, les bis(hydroxy-4 phényl)tolyl-méthanes ; le résorcinol ; l'hydroquinone ; le pyrocatéchol ; le dihydroxy-4,4'diphényle ; et les produits de condensation des phénols précités avec un aldéhyde ; ou (2i) un mélange d'une pareille résine époxy chlorée ou bromée avec une résine époxy de même nature, mais non halogénée.

5. Procédé de préparation de polymères à groupements imides se trouvant sous forme de prépolymères thermodurcissables (P) solubles dans les solvants organiques polaires usuels et présentant un point de ramollissement à une température inférieure à 200°C, qui consiste à chauffer directement le mélange des ingrédients (a) + (b) + éventuellement (c) + éventuellement (d) définis ci-avant dans l'une quelconque des revendications 1 à 3 à une température comprise entre 50°C et 180°C jusqu'à l'obtention d'un produit homogène ou pâteux,
   ledit procédé étant caractérisé en ce que le milieu de réaction contient en outre un additif (e) répondant à la définition donnée ci-avant dans l'une quelconque des revendications 1 et 4.

6. Procédé selon la revendication 1, caractérisé en ce qu'il consiste à chauffer le mélange des ingrédients de départ entre 50°C et 180°C pour former dans un premier temps un prépolymère (P), puis à provoquer le durcissement du prépolymère (P) par chauffage à une température comprise entre 150°C et 300°C.

7. Procédé selon l'une quelconque des revendications 1 à 6, caractérisé en ce que le réactif facultatif (c), quand il est utilisé, est employé en quantités représentant moins de 60 % du poids total des réactifs (a) + (b).

8. Procédé selon l'une quelconque des revendications 1 à 6, caractérisé en ce que le composé imidazole facultatif (d), quand il est utilisé, est employé en quantités se situant dans l'intervalle allant de 0,005 à 1 % en poids par rapport à l'ensemble des réactifs (a) + (b) + éventuellement (c).

9. Procédé selon l'une quelconque des revendications 1 à 8, caractérisé en ce que la quantité de chlore ou de brome apportée par l'additif (e), exprimée par le pourcentage en poids de chlore élémentaire ou de brome élémentaire par rapport au poids du mélange global bis-imide(s) (a) + diamine(s) (b) + réactif facultatif (c) + additif (e), représente au plus 6 %.

## Patentansprüche

### Patentansprüche für folgende Vertraggstaaten : BE, CH, DE, FR, GB, IT, LI, NL, SE

1. Polymere mit Imid-Gruppen, dadurch gekennzeichnet, daß sie das Produkt einer bei einer Temperatur von 50 °C bis 300 °C durchgeführten Reaktion umfassen, und zwar zwischen
   (a) einem N,N'-Bis-Imid oder einer Assoziation mehrerer Bis-Imide der Formel (I)

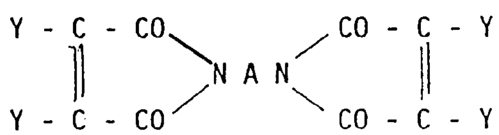

(I)

in der
. die Symbole Y, gleich oder verschieden, jeweils Wasserstoff, $CH_3$ oder Chlor darstellen,
. das Symbol A einen divalenten Rest bedeutet, ausgewählt aus der Gruppe der folgenden Reste: Cyclohexylen, Phenylen, 4-Methyl-1,3-Phenylen, 2-Methyl-1,3-Phenylen, 5-Methyl-1,3-Phenylen, 2,5-Diethyl-3-methyl-1,4-phenylen und den Resten der Formel

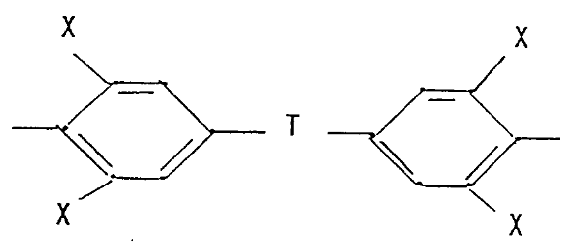

in der T eine einfache Valenzbindung oder eine Gruppe:

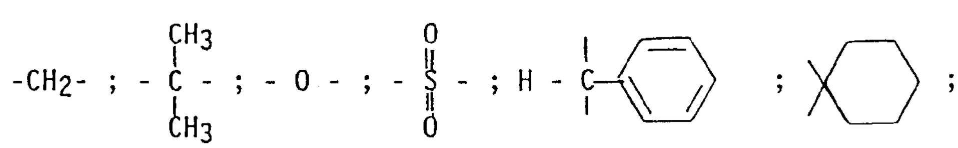

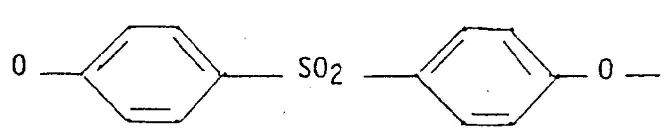

darstellt und die Symbole X, gleich oder verschieden, jeweils ein Wasserstoffatom, einen Methyl-, Ethyl- oder Isopropyl-Rest bedeuten,
(b) einem oder mehreren sperrigen biprimären Diaminen, ausgewählt aus der folgenden Gruppe:
(i) den Gattungen der allgemeinen Formel (II)

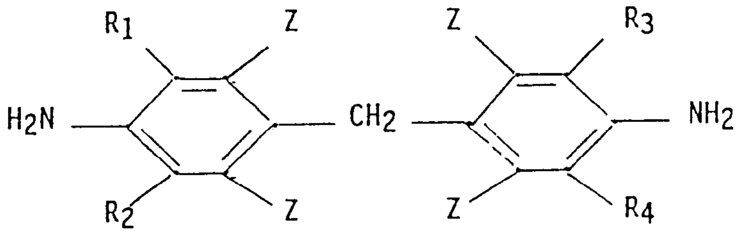

(II)

in der:

. die Symbole $R_1$, $R_2$, $R_3$ und $R_4$, gleich oder verschieden, jeweils einen Methyl-, Ethyl-, Propyl- oder Isopropyl-Rest darstellen,

. die Symbole Z, gleich oder verschieden, jeweils ein Wasserstoffatom oder ein Chloratom bedeuten,

(2i) und den Gattungen der allgemeinen Formel (III)

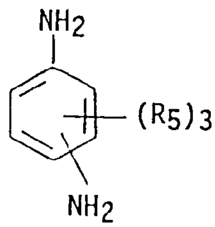

(III)

in der

. die Amino-Reste zueinander in meta- oder para-Position stehen,

. die Symbole $R_5$, gleich oder verschieden, jeweils einen Methyl-, Ethyl-, Propyl- oder Isopropyl-Rest darstellen,

(c) gegebenenfalls einem oder mehreren nicht halogenierten Monomeren, die kein Bis-Imid der Formel (I) darstellen und die eine oder mehrere polymerisierbare Kohlenstoff-Kohlenstoff-Doppelbindungen umfassen,

(d) gegebenenfalls einer Verbindung vom Typ Imidazol, und mit Mengen der Verbindungen (a) und (b), die so gewählt werden, daß man ein Verhältnis r:

$$\frac{\text{Anzahl der Mole Bis–Imid (a)}}{\text{Anzahl der Mole Diamin (b)}}$$

erhält, das im Intervall von 1,1/l bis 20/l liegt,

wobei die genannten Polymere mit Imid-Gruppen dadurch gekennzeichnet sind, daß das zu ihrer Herstellung dienende Reaktionsmedium außerdem einen Zusatz (e) enthält, der mindestens aus einem chlorierten oder bromierten Epoxy-Harz (e1) besteht, gegebenenfalls in Mischung mit einem nicht halogenierten Epoxy-Harz, gegebenenfalls mit mindestens einem N,N′-Alkylen-bis-tetrahalogen-phthalimid (e2) der Formel (IV)

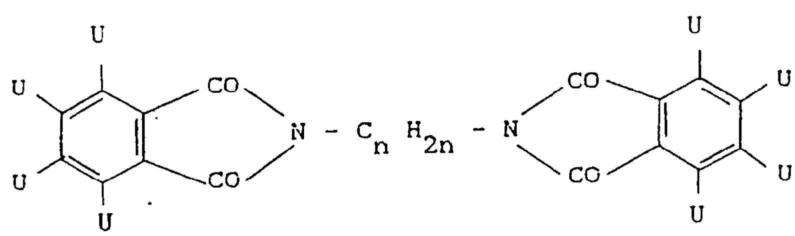

(IV)

in der

. die Symbole U, gleich oder verschieden, jeweils ein Chlor- oder Bromatom darstellen,

. der Alkylen-Rest $-C_nH_{2n}-$ linear oder verzweigt sein kann,

. n eine ganze Zahl von 1, 2, 3 oder 4 ist, und

gegebenenfalls mit mindestens einem halogenierten Produkt (e3) der Formel (V)

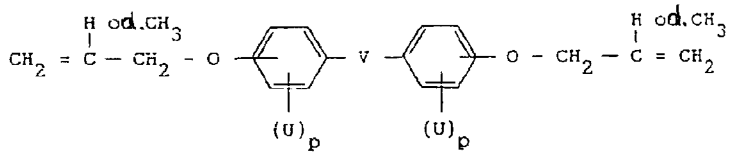

(V)

in der

. die Symbole U die oben angegebene Bedeutung besitzen,

. das Symbol V eine einfache Valenzbindung, einen linearen oder verzweigten Alkylen-Rest $-C_nH_{2n}-$ mit n gleich 1, 2, 3 oder 4 oder ein Sauerstoffatom bedeutet,

. p eine ganze Zahl von 2, 3 oder 4 ist,

und dadurch, daß die Menge der Verbindung (e) 2 bis 30 Prozent des Gewichtes der Mischung Bis-Imide (a) + Diamin(e) (b) + gegebenenfalls Reaktionspartner (c) beträgt.

**2.** Polymere nach Anspruch 1, dadurch gekennzeichnet, daß der Reaktionspartner (a) aus der folgenden Gruppe ausgewählt wird:
- N,N′-Metaphenylen-bis-maleimid,
- N,N′-Paraphenylen-bis-maleimid,
- N,N′-4,4′-Diphenylmethan-bis-maleimid,
- N,N′-4,4′-Diphenylether-bis-maleimid,
- N,N′-4,4′-Diphenylsulfon-bis-maleimid,
- N,N′-1,4-Cyclohexylen-bis-maleimid,
- N,N′-4,4′-(1,1-Diphenyl-cyclohexan)-bis-maleimid,
- N,N′-4,4′-(2,2-Diphenyl-propan)-bis-maleimid,
- N,N′-4,4′-Triphenylmethan-bis-maleimid,
- N,N′-2-Methyl-1,3-phenylen-bis-maleimid,
- N,N′-4-Methyl-1,3-phenylen-bis-maleimid,
- N,N′-5-Methyl-1,3-phenylen-bis-maleimid,
- ihren Mischungen.

**3.** Polymere nach irgendeinem der Ansprüche 1 und 2, dadurch gekennzeichnet, daß der Reaktionspartner (b) aus der folgenden Gruppe ausgewählt wird:
- 4,4′-Diamino-3,3′,5,5′-tetramethyl-diphenylmethan,
- 4,4′-Diamino-3,3′,5,5′-tetraethyl-diphenylmethan,
- 4,4′-Diamino-3,5-dimethyl-3′,5′-diethyl-diphenylmethan,
- 4,4′-Diamino-3,3′-diethyl-5,5′-dimethyl-diphenylmethan,
- 4,4′-Diamino-3,3′,5,5′-tetraisopropyl-diphenylmethan,
- 4,4′-Diamino-3,3′-diisopropyl-5,5′-dimethyl-diphenylmethan,
- 1,3-Diamino-2,4-diethyl-6-methyl-benzol,
- 1,3-Diamino-2-methyl-4,6-diethyl-benzol,
- und ihren Mischungen.

**4.** Polymere nach irgendeinem der Ansprüche 1 bis 3, dadurch gekennzeichnet, daß der Zusatz (e1) mindestens aus einer aus der folgenden Gruppe ausgewählten Verbindung besteht:

∗ (e1) : (i) einem bromierten oder chlorierten Epoxy-Harz mit einem Epoxy-Äquivalent-Gewicht zwischen 200 und 2000, das aus einem Glycid-Ether besteht, erhalten durch Reaktion mit dem Epichlorhydrin eines Derivates, das an dem oder den aromatischen Kern(en) bromiert oder chloriert ist, stammend von einem Polyphenol, ausgewählt aus der folgenden Gruppe: Familie der Bis-(Hydroxyphenyl)-alkane, wie das Bis-2,2-(4-Hydroxyphenyl)-propan, das Bis(4-Hydroxyphenyl)-methan, das Bis-(4-Hydroxyphenyl)-methyl-phenyl-methan, die Bis-(4-Hydroxyphenyl)-tolyl-methane; dem Resorzin; dem Hydrochinon, dem Brenzkatechin; dem 4,4′-Dihydroxy-diphenyl; und den Kondensationsprodukten der obengenannten Phenole mit einem Aldehyd; oder (2i) einer Mischung eines ähnlichen, bromierten oder chlorierten Epoxy-Harzes mit einem Epoxy-Harz der gleichen Beschaffenheit, jedoch nicht halogeniert.

**5.** Polymere nach irgendeinem der Ansprüche 1 bis 4, dadurch gekennzeichnet, daß der wahlweise Reaktionspartner (c), wenn er verwendet wird, in einer Menge von mindestens 60 % des Gesamtgewichtes

der Reaktionspartner (a) + (b) eingesetzt wird.

6. Polymere nach irgendeinem der Ansprüche 1 bis 5, dadurch gekennzeichnet, daß die wahlweise Imidazol-Verbindung (d), wenn sie verwendet wird, in einer Menge eingesetzt wird, die im Intervall von 0,005 bis 1 Gewichtsprozent liegt, bezogen auf die Gesamtheit der Reaktionspartner (a) + (b) + gegebenenfalls (c).

7. Polymere nach irgendeinem der Ansprüche 1 bis 6, dadurch gekennzeichnet, daß die Menge an durch den Zusatz (e) eingebrachtem Chlor oder Brom, ausgedrückt in Gewichtsprozent elementares Chlor oder elementares Brom, in bezug auf die Gesamtmischung Bis-Imid(e) (a) + Diamin(e) (b) + wahlweiser Reaktionspartner (c) + Zusatz (e), höchstens 6 % beträgt.

8. Polymere nach irgendeinem der Ansprüche 1 bis 7, dadurch gekennzeichnet, daß sie in Form von gehärteten Polymeren vorliegen, unlöslich in üblichen polaren organischen Lösungsmitteln, und keine nennenswerte Erweichung unterhalb der Temperatur aufweisen, bei der sie beginnen sich zu zersetzen.

9. Polymere nach irgendeinem der Ansprüche 1 bis 7, dadurch gekennzeichnet, daß sie in Form von wärmehärtbaren Prepolymeren (P) vorliegen, löslich in üblichen polaren organischen Lösungsmitteln, und einen Erweichungspunkt bei einer Temperatur von unterhalb 200 °C aufweisen.

**Patentansprüche für folgenden Vertragsstaat : ES**

1. Verfahren zur Herstellung von Polymeren mit Imid-Gruppen, die in Form von gehärteten Polymeren vorliegen, unlöslich in üblichen polaren organischen Lösungsmitteln, und die keine nennenswerte Erweichung unterhalb der Temperatur aufweisen, bei der sie beginnen sich zu zersetzen, das darin besteht, die Mischung der folgenden Bestandteile direkt auf eine Temperatur zwischen 50 °C und 300 °C zu erhitzen:

(a) ein N,N'-Bis-Imid oder eine Assoziation mehrerer Bis-Imide der Formel (I)

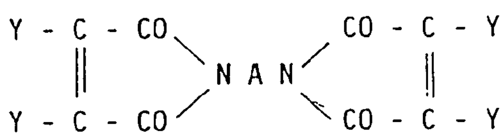 (I)

in der

. die Symbole Y, gleich oder verschieden, jeweils Wasserstoff, $CH_3$ oder Chlor darstellen,

. das Symbol A einen divalenten Rest bedeutet, ausgewählt aus der Gruppe der folgenden Reste: Cyclohexylen, Phenylen, 4-Methyl-1,3-Phenylen, 2-Methyl-1,3-Phenylen, 5-Methyl-1,3-Phenylen, 2,5-Diethyl-3-methyl-1,4-phenylen und den Resten der Formel

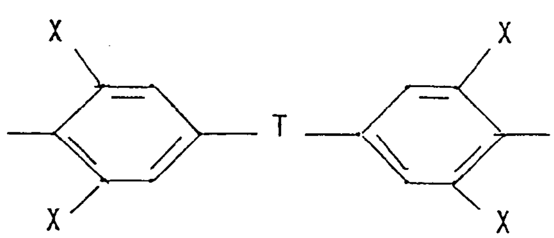

in der T eine einfache Valenzbindung oder eine Gruppe:

$-CH_2-$ ; 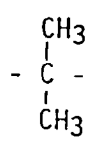 ; $-O-$ ; 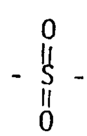 ; 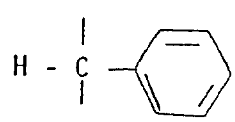 ; 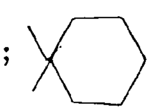 ;

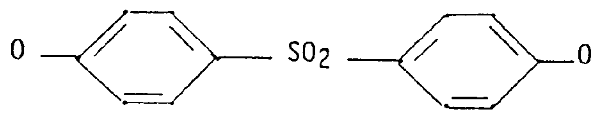

darstellt und die Symbole X, gleich oder verschieden, jeweils ein Wasserstoffatom, einen Methyl-, Ethyl- oder Isopropyl-Rest bedeuten,

(b) ein oder mehrere sperrige biprimäre Diamine, ausgewählt aus der folgenden Gruppe:

(i) den Gattungen der allgemeinen Formel (II)

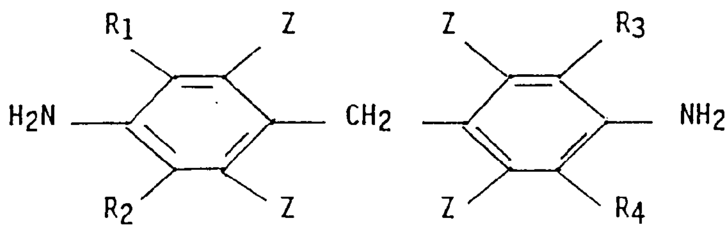

(II)

in der:

. die Symbole $R_1$, $R_2$, $R_3$ und $R_4$, gleich oder verschieden, jeweils einen Methyl-, Ethyl-, Propyl- oder Isopropyl-Rest darstellen,

. die Symbole Z, gleich oder verschieden, jeweils ein Wasserstoffatom oder ein Chloratom bedeuten,

(2i) und den Gattungen der allgemeinen Formel (III)

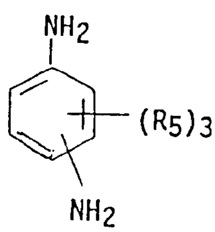

(III)

in der

. die Amino-Reste zueinander in meta- oder para-Position stehen,

. die Symbole $R_5$, gleich oder verschieden, jeweils einen Methyl-, Ethyl-, Propyl- oder Isopropyl-Rest darstellen,

(c) gegebenenfalls ein oder mehrere nicht halogenierte Monomere, die kein Bis-Imid der Formel (I) darstellen und die eine oder mehrere polymerisierbare Kohlenstoff-Kohlenstoff-Doppelbindungen umfassen,

(d) gegebenenfalls eine Verbindung vom Typ Imidazol, und mit Mengen der Verbindungen (a) und (b), die so gewählt werden, daß man ein Verhältnis r:

$$\frac{\text{Anzahl der Mole Bis–Imid (a)}}{\text{Anzahl der Mole Diamin (b)}}$$

erhält, das im Intervall von 1,1/l bis 20/l liegt, wobei das genannte Verfahren dadurch gekennzeichnet ist, daß das Reaktions-medium außerdem einen Zusatz (e) enthält, der mindestens aus einem chlorierten oder bromierten Epoxy-Harz (e1) besteht, gegebenenfalls in Mischung mit einem nicht halogenierten Epoxy-Harz, gegebenenfalls mit mindestens einem N,N'-Alkylen-bis-tetrahalogen-phthalimid (e2) der Formel (IV)

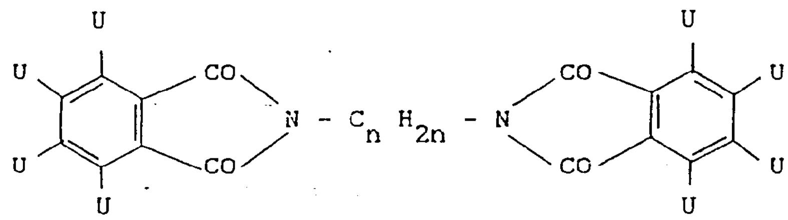

(IV)

in der

. die Symbole U, gleich oder verschieden, jeweils ein Chlor- oder Bromatom darstellen,

. der Alkylen-Rest $-C_nH_{2n}-$ linear oder verzweigt sein kann,

. n eine ganze Zahl von 1, 2, 3 oder 4 ist, und gegebenenfalls mit mindestens einem halogenierten Produkt (e3) der Formel (V)

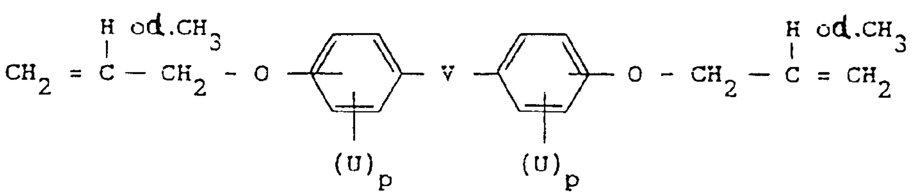

(V)

in der

. die Symbole U die oben angegebene Bedeutung besitzen,

. das Symbol V eine einfache Valenzbindung, einen linearen oder verzweigten Alkylen-Rest $-C_nH_{2n}-$ mit n gleich 1, 2, 3 oder 4 oder ein Sauerstoffatom bedeutet,

. p eine ganze Zahl von 2, 3 oder 4 ist,

und dadurch, daß die Menge der Verbindung (e) 2 bis 30 Prozent des Gewichtes der Mischung Bis-Imide (a) + Diamin(e) (b) + gegebenenfalls Reaktionspartner (c) beträgt.

2. Verfahren nach Anspruch 1, dadurch gekennzeichnet, daß der Reaktionspartner (a) aus der folgenden Gruppe ausgewählt wird:
   - N,N'-Metaphenylen-bis-maleimid,
   - N,N'-Paraphenylen-bis-maleimid,
   - N,N'-4,4'-Diphenylmethan-bis-maleimid,
   - N,N'-4,4'-Diphenylether-bis-maleimid,
   - N,N'-4,4'-Diphenylsulfon-bis-maleimid,
   - N,N'-1,4-Cyclohexylen-bis-maleimid,
   - N,N'-4,4'-(1,1-Diphenyl-cyclohexan)-bis-maleimid,
   - N,N'-4,4'-(2,2-Diphenyl-propan)-bis-maleimid,
   - N,N'-4,4'-Triphenylmethan-bis-maleimid,
   - N,N'-2-Methyl-1,3-phenylen-bis-maleimid,
   - N,N'-4-Methyl-1,3-phenylen-bis-maleimid,
   - N,N'-5-Methyl-1,3-phenylen-bis-maleimid,
   - ihren Mischungen.

3. Verfahren nach irgendeinem der Ansprüche 1 und 2, dadurch gekennzeichnet, daß der Reaktionspartner (b) aus der folgenden Gruppe ausgewählt wird:
   - 4,4'-Diamino-3,3',5,5'-tetramethyl-diphenylmethan,
   - 4,4'-Diamino-3,3',5,5'-tetraethyl-diphenylmethan,
   - 4,4'-Diamino-3,5-dimethyl-3',5'-diethyl-diphenylmethan,
   - 4,4'-Diamino-3,3'-diethyl-5,5'-dimethyl-diphenylmethan,
   - 4,4'-Diamino-3,3',5,5'-tetraisopropyl-diphenylmethan,
   - 4,4'-Diamino-3,3'-diisopropyl-5,5'-dimethyl-diphenylmethan,
   - 1,3-Diamino-2,4-diethyl-6-methyl-benzol,
   - 1,3-Diamino-2-methyl-4,6-diethyl-benzol,

- und ihren Mischungen.

4. Verfahren nach irgendeinem der Ansprüche 1 bis 3, dadurch gekennzeichnet, daß der Zusatz (e) mindestens aus einer aus der folgenden Gruppe ausgewählten Verbindung besteht:
   * (e1) : (i) einem bromierten oder chlorierten Epoxy-Harz mit einem Epoxy-Äquivalent-Gewicht zwischen 200 und 2000, das aus einem Glycid-Ether besteht, erhalten durch Reaktion mit dem Epichlorhydrin eines Derivates, das an dem oder den aromatischen Kern(en) bromiert oder chloriert ist, stammend von einem Polyphenol, ausgewählt aus der folgenden Gruppe: Familie der Bis-(Hydroxyphenyl)-alkane, wie das Bis-2,2-(4-Hydroxyphenyl)-propan, das Bis-(4-Hydroxyphenyl)-methan, das Bis-(4-Hydroxyphenyl)-methyl-phenyl-methan, die Bis-(4-Hydroxyphenyl)-tolyl-methane; dem Resorzin; dem Hydrochinon, dem Brenzkatechin; dem 4,4'-Dihydroxy-diphenyl; und den Kondensationsprodukten der obengenannten Phenole mit einem Aldehyd; oder (2i) einer Mischung eines ähnlichen, bromierten oder chlorierten Epoxy-Harzes mit einem Epoxy-Harz der gleichen Beschaffenheit, jedoch nicht halogeniert.

5. Verfahren zur Herstellung von Polymeren mit Imid-Gruppen, die in Form von wärmehärtbaren Prepolymeren (P) vorliegen, löslich in üblichen polaren organischen Lösungsmitteln, und die einen Erweichungspunkt bei einer Temperatur von unterhalb 200 °C aufweisen, das darin besteht, die Mischung der vorstehend in irgendeinem der Ansprüche 1 bis 3 definierten Bestandteile (a) + (b) + gegebenenfalls (c) + gegebenenfalls (d) auf eine Temperatur zwischen 50 °C und 180 °C bis zum Vorliegen eines homogenen oder pastösen Produktes zu erhitzen, wobei das Verfahren dadurch gekennzeichnet ist, daß das Reaktionsmilieu außerdem einen Zusatz (e) enthält, der der vorstehend in irgendeinem der Ansprüche 1 und 4 gegebenen Definition entspricht.

6. Verfahren nach Anspruch 1, dadurch gekennzeichnet, daß es darin besteht, die Mischung der Ausgangsprodukte auf eine Temperatur zwischen 50 °C und 180 °C zu erhitzen, um in einer ersten Phase ein Prepolymer (P) zu bilden, und anschließend die Härtung des Prepolymers (P) durch Erhitzen auf eine Temperatur zwischen 150 °C und 300 °C herbeizuführen.

7. Verfahren nach irgendeinem der Ansprüche 1 bis 6, dadurch gekennzeichnet, daß der wahlweise Reaktionspartner (c), wenn er verwendet wird, in einer Menge von mindestens 60 % des Gesamtgewichtes der Reaktionspartner (a) + (b) eingesetzt wird.

8. Verfahren nach irgendeinem der Ansprüche 1 bis 6, dadurch gekennzeichnet, daß die wahlweise Imidazol-Verbindung (d), wenn sie verwendet wird, in einer Menge eingesetzt wird, die im Intervall von 0,005 bis 1 Gewichtsprozent liegt, bezogen auf die Gesamtheit der Reaktionspartner (a) + (b) + gegebenenfalls (c).

9. Verfahren nach irgendeinem der Ansprüche 1 bis 8, dadurch gekennzeichnet, daß die Menge an durch den Zusatz (e) eingebrachtem Chlor oder Brom, ausgedrückt in Gewichtsprozent elementares Chlor oder elementares Brom, in bezug auf das Gewicht der Gesamtmischung Bis-Imid(e) (a) + Diamin(e) (b) + wahlweiser Reaktionspartner (c) + Zusatz (e), höchstens 6 % beträgt.

## Claims

### Claims for the following Contracting States : BE, CH, DE, FR, GB, IT, LI, NL, SE

1. Polymers containing imide groups, characterized in that they comprise the product of reaction, at a temperature ranging from 50°C to 300°C, between:
   - (a) an N,N'-bisimide or a combination of various bisimides of formula:

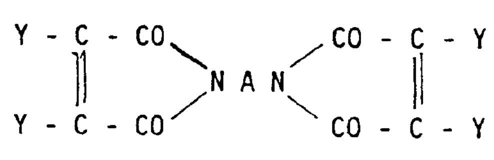

(I)

   in which:
   each of the symbols Y, which are identical or different, denotes H, $CH_3$ or Cl;

the symbol A denotes a divalent radical chosen from the group consisting of the following radicals: cyclohexylenes, phenylenes, 4-methyl-1,3-phenylene, 2-methyl-1,3-phenylene, 5-methyl-1,3-phenylene, 2,5-diethyl-3-methyl-1,4-phenylene, and the radicals of formula:

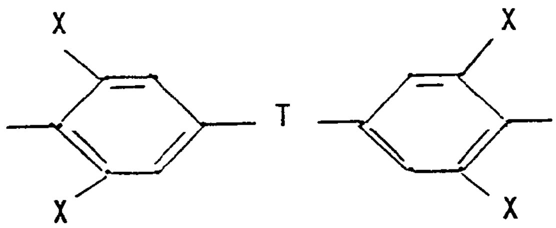

in which T denotes a single valency bond or a group:

$-CH_2-$ ; - 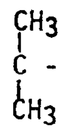 - ; - O - ; - 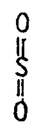 - ; H - 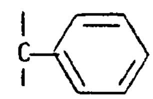 ; 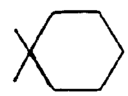 ;

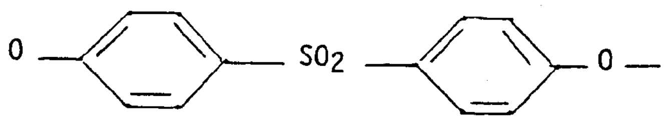

and each of the symbols X, which are identical or different, denotes a hydrogen atom or a methyl, ethyl or isopropyl radical;

- (b) one or more hindered diprimary diamine(s) taken from the group made up of:

(i) the species corresponding to the general formula:

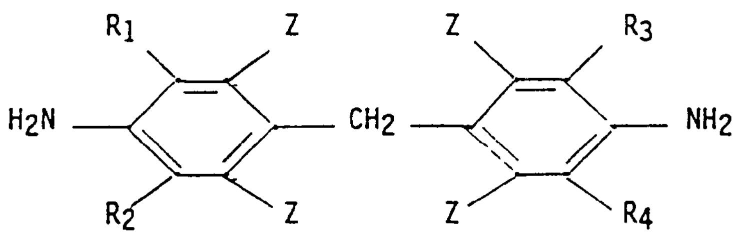

(II)

in which:

each of the symbols $R_1$, $R_2$, $R_3$ and $R_4$, which are identical or different, denotes a methyl, ethyl, propyl or isopropyl radical;

each of the symbols Z, which are identical or different, denotes a hydrogen atom or a chlorine atom;

(ii) and the species corresponding to the general formula:

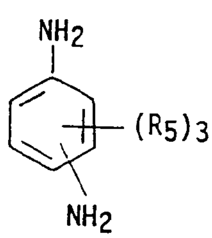

(III)

in which:

the amino radicals are in a meta or para position relative to each other;
each of the symbols $R_5$, which are identical or different, denotes a methyl, ethyl, propyl or isopropyl radical;

- (c) optionally one or more unhalogenated monomer(s) other than a bisimide of formula (I) and containing one or more polymerizable carbon-carbon double bond(s);
- (d) optionally a compound of the imidazole type; and with quantities of compounds (a) and of compounds (b) chosen so as to obtain a ratio r:

$$\frac{\text{numbers of moles of bisimides (a)}}{\text{number of moles of diamines (b)}}$$

within the range from 1.1/l to 20/l; the said polymers containing imide groups being characterized in that the reaction mixture which is used to prepare them additionally contains an additive (e) consisting of at least one chorinated or brominated epoxy resin (e1) optionally mixed with an unhalogenated epoxy resin, optionally at least one N,N'-alkylenebistetrahalophthalimide (e2) of formula:

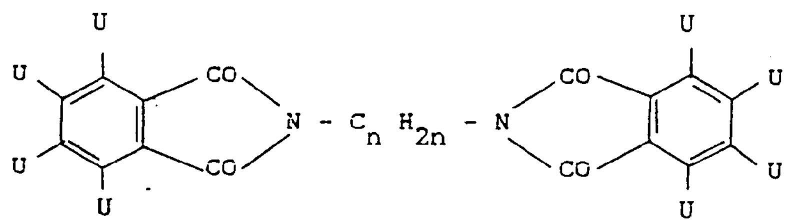

(IV)

in which:
each of the symbols U, which are identical or different, denotes a chlorine or bromine atom;
the alkylene radical $-C_nH_{2n}-$ may be linear or branched;
n is an integer equal to 1, 2, 3 or 4;
and optionally at least one halogenated product (e3) of formula:

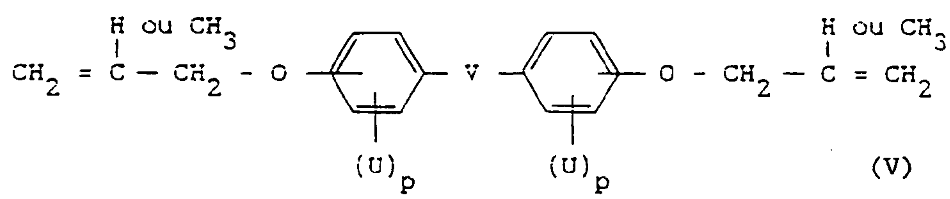

(V)

in which:
the symbols U have the meaning given above;
the symbol V denotes a single valency bond, a linear or branched $-C_nH_{2n}-$alkylene radical, with n being equal to 1, 2, 3 or 4, or an oxygen atom; p is an integer equal to 2, 3 or 4, and in that the quantity of compound (e) represents 2 to 30% by weight of the mixture of bisimides (a) and diamine(s) (b) and optionally reactant (c).

2. Polymers according to claim 1, characterized in that the reactant (a) is taken from the group made up of:
- N,N'-meta-phenylenebismaleimide,
- N,N'-para-phenylenebismaleimide,
- N,N'-4,4'-diphenylmethanebismaleimide,
- N,N'-4,4'-diphenyl ether bismaleimide,
- N,N'-4,4'-diphenyl sulfone bismaleimide,
- N,N'-1,4-cyclohexylenebismaleimide,
- N,N'-4,4'-(1,1-diphenylcyclohexane)bismaleimide,
- N,N'-4,4'-(2,2-diphenylpropane)bismaleimide,
- N,N'-4,4'-triphenylmethanebismaleimide,
- N,N'-2-methyl-1,3-phenylenebismaleimide,
- N,N'-4-methyl-1,3-phenylenebismaleimide,
- N,N'-5-methyl-1,3-phenylenebismaleimide,
- and mixtures thereof.

3. Polymers according to either of claims 1 and 2, characterized in that the reactant (b) is taken from the group made up of:
   - 4,4′-diamino-3,3′,5,5′-tetramethyldiphenylmethane,
   - 4,4′-diamino-3,3′,5,5′-tetraethyldiphenylmethane,
   - 4,4′-diamino-3,5-dimethyl-3′,5′-diethyldiphenylmethane,
   - 4,4′-diamino-3,3′-diethyl-5,5′-dimethyldiphenylmethane,
   - 4,4′-diamino-3,3′,5,5′-tetraisopropyldiphenylmethane,
   - 4,4′-diamino-3,3′-diisopropyl-5,5′-dimethyldiphenylmethane,
   - 1,3-diamino-2,4-diethyl-6-methylbenzene,
   - 1,3-diamino-2-methyl-4,6-diethylbenzene,
   - and mixtures thereof.

4. Polymers according to any one of claims 1 to 3, characterized in that the additive (e1) consists of at least one compound chosen from the group made up of:
   (e1): (i) a chlorinated or brominated epoxy resin which has an epoxy equivalent weight of between 200 and 2,000 and which consists of a glycidyl ether obtained by reacting with epichlorohydrin a derivative which is chlorinated or brominated on the aromatic nucleus or nuclei and originates from a polyphenol chosen from the group made up of: the class of bis(hydroxyphenyl)alkanes such as 2,2-bis(4-hydroxyphenyl)propane, bis(4-hydroxyphenyl)methane, bis(4-hydroxyphenyl)methylphenylmethane and bis(4-hydroxyphenyl)tolylmethanes, resorcinol, hydroquinone, pyrocatechol, 4,4′-dihydroxybiphenyl, and the products of condensation of the abovementioned phenols with an aldehyde; or (ii) a mixture of such a chlorinated or brominated epoxy resin with an epoxy resin of the same kind, but not halogenated.

5. Polymers according to any one of claims 1 to 4, characterized in that the optional reactant (c), when used, is employed in quantities representing less than 60 % of the total weight of the reactants (a) + (b).

6. Polymers according to any one of claims 1 to 5, characterized in that the optional imidazole compound (d), when used, is employed in quantities situated in the range from 0.005 to 1 % by weight relative to the total of the reactants (a) + (b) + optionally (c).

7. Polymers according to any one of claims 1 to 6, characterized in that the quantity of chlorine or of bromine contributed by the additive (e), expressed as the weight percentage of elemental chlorine or of elemental bromine relative to the weight of the overall mixture of bisimide(s) (a) + diamine(s) (b) + optional reactant (c) + additive (e), represents not more than 6 %.

8. Polymers according to any one of claims 1 to 7, characterized in that they are in the form of cured polymers, insoluble in the usual polar organic solvents and exhibiting no appreciable softening below the temperature at which they begin to degrade.

9. Polymers according to any one of claims 1 to 7, characterized in that they are in the form of heat-curable prepolymers (P) which are soluble in the usual polar organic solvents and have a softening point at a temperature below 200°C.

**Claims for the following Contracting State : ES**

1. Process for the preparation of polymers containing imide groups which are in the form of cured polymers, insoluble in the usual polar organic solvents and exhibiting no appreciable softening below the temperature at which they begin to degrade, which consists in heating directly at a temperature of between 50°C and 300°C the mixture of the following ingredients:
   - (a) an N,N′-bisimide or a combination of a number of bisimides of formula:

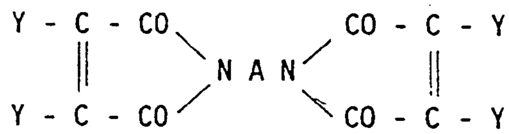

(I)

in which:
each of the symbols Y, which are identical or different, denotes H, $CH_3$ or Cl;
the symbol A denotes a divalent radical chosen from the group consisting of the following radicals: cyclohexylenes, phenylenes, 4-methyl-1,3-phenylene, 2-methyl-1,3-phenylene, 5-methyl-1,3-phenylene, 2,5-diethyl-3-methyl-1,4-phenylene, and the radicals of formula:

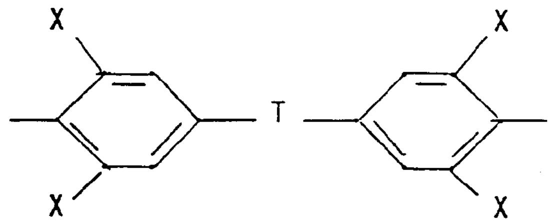

in which T denotes a single valency bond or a group:

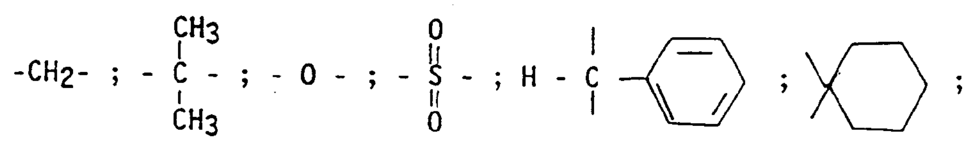

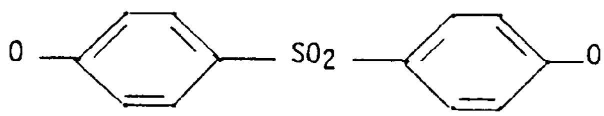

and each of the symbols X, which are identical or different, denotes a hydrogen atom or a methyl, ethyl or isopropyl radical;
- (b) one or more hindered diprimary diamine(s) taken from the group made up of:
  (i) the species corresponding to the general formula:

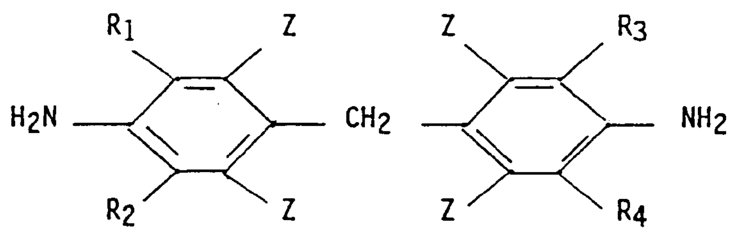

(II)

in which:
each of the symbols $R_1$, $R_2$, $R_3$ and $R_4$, which are identical or different, denotes a methyl, ethyl, propyl or isopropyl radical;
each of the symbols Z, which are identical or different, denotes a hydrogen atom or a chlorine atom;
(ii) and the species corresponding to the general formula:

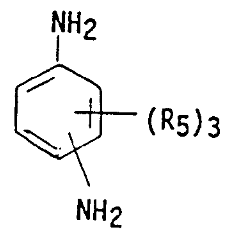

(III)

in which: the amino radicals are in a meta or para position relative to each other; each of the symbols $R_5$, which are identical or different, denotes a methyl, ethyl, propyl or isopropyl radical;

- (c) optionally one or more unhalogenated monomer(s) other than a bisimide of formula (I) and containing one or more polymerizable carbon-carbon double bond(s);
- (d) optionally a compound of the imidazole type; and with quantities of compounds (a) and of compounds (b) chosen so as to obtain a ratio r:

$$\frac{\text{numbers of moles of bisimides (a)}}{\text{number of moles of diamines (b)}}$$

within the range from 1.1/l to 20/l; the said process being characterized in that the reaction mixture additionally contains an additive (e) consisting of at least one chlorinated or brominated epoxy resin (e1) optionally mixed with an unhalogenated epoxy resin, optionally at least one N,N'-alkylenebistetrahalophthalimide (e2) of formula:

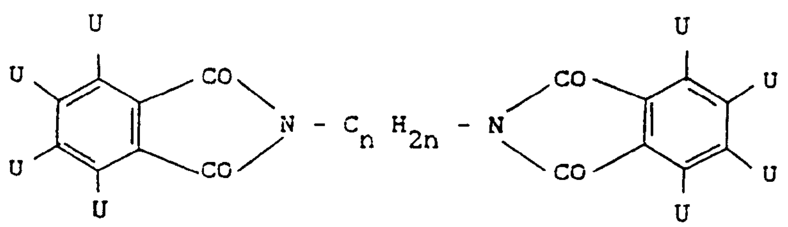

(IV)

in which: each of the symbols U, which are identical or different, denotes a chlorine or bromine atom; the alkylene radical $-C_nH_{2n}-$ may be linear or branched; n is an integer equal to 1, 2, 3 or 4; and optionally at least one halogenated product (e3) of formula:

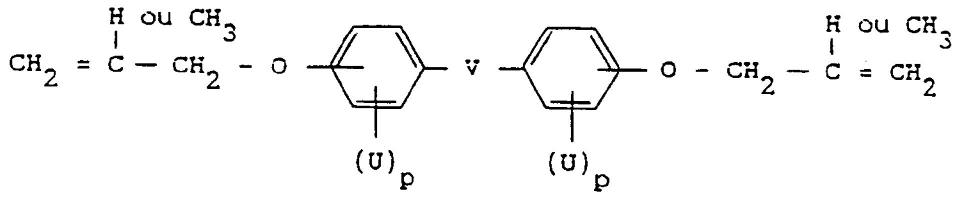

(V)

in which: the symbols U have the meaning given above; the symbol V denotes a single valency bond, a linear or branched $-C_nH_{2n}-$alkylene radical, with n being equal to 1, 2, 3 or 4, or an oxygen atom; p is an integer equal to 2, 3 or 4, and in that the quantity of compound (e) represents 2 to 30% by weight of the mixture of bisimides (a) and diamine(s) (b) and optionally reactant (c).

2. Process according to claim 1, characterized in that the reactant (a) is taken from the group made up of:
- N,N′-meta-phenylenebismaleimide,
- N,N′-para-phenylenebismaleimide,
- N,N′-4,4′-diphenylmethanebismaleimide,
- N,N′-4,4′-diphenyl ether bismaleimide,
- N,N′-4,4′-diphenyl sulfone bismaleimide,
- N,N′-1,4-cyclohexylenebismaleimide,
- N,N′-4,4′-(1,1-diphenylcyclohexane)bismaleimide,
- N,N′-4,4′-(2,2-diphenylpropane)bismaleimide,
- N,N′-4,4′-triphenylmethanebismaleimide,
- N,N′-2-methyl-1,3-phenylenebismaleimide,
- N,N′-4-methyl-1,3-phenylenebismaleimide,
- N,N′-5-methyl-1,3-phenylenebismaleimide,
- and mixtures thereof.

3. Process according to either of claims 1 and 2, characterized in that the reactant (b) is taken from the group made up of:
- 4,4′-diamino-3,3′,5,5′-tetramethyldiphenylmethane,
- 4,4′-diamino-3,3′,5,5′-tetraethyldiphenylmethane,
- 4,4′-diamino-3,5-dimethyl-3′,5′-diethyldiphenylmethane,
- 4,4′-diamino-3,3′-diethyl-5,5′-dimethyldiphenylmethane,
- 4,4′-diamino-3,3′, 5,5′-tetraisopropyldiphenylmethane,
- 4,4′-diamino-3,3′-diisopropyl-5,5′-dimethyldiphenylmethane,
- 1,3-diamino-2,4-diethyl-6-methylbenzene,
- 1,3-diamino-2-methyl-4,6-diethylbenzene,
- and mixtures thereof.

4. Process according to any one of claims 1 to 3, characterized in that the additive (e) consists of at least one compound chosen from the group made up of:
(e1): (i) a chlorinated or brominated epoxy resin which has an epoxy equivalent weight of between 200 and 2,000 and which consists of a glycidyl ether obtained by reacting with epichlorohydrin a derivative which is chlorinated or brominated on the aromatic nucleus or nuclei and originates from a polyphenol chosen from the group made up of: the class of bis(hydroxyphenyl)alkanes such as 2,2-bis(4-hydroxyphenyl)propane, bis(4-hydroxyphenyl)methane, bis(4-hydroxyphenyl)methylphenylmethane and bis(4-hydroxyphenyl)tolylmethanes, resorcinol, hydroquinone, pyrocatechol, 4,4′-dihydroxybiphenyl, and the products of condensation of the abovementioned phenols with an aldehyde; or (ii) a mixture of such a chlorinated or brominated epoxy resin with an epoxy resin of the same kind, but not halogenated.

5. Process for the preparation of polymers containing imide groups which are in the form of heat-curable prepolymers (P) soluble in the usual polar organic solvents and exhibiting a softening point at a temperature below 200°C, which consists in heating directly the mixture of the ingredients (a) + (b) + optionally (c) + optionally (d) which are defined above in any one of claims 1 to 3 at a temperature of between 50°C and 180°C until a homogeneous or pasty product is obtained, the said process being characterised in that the reaction mixture additionally contains an additive (e) corresponding to the definition given above in either of claims 1 and 4.

6. Process according to claim 1, characterized in that it consists in heating the mixture of the starting ingredients between 50°C and 180°C to form, in a first step, a prepolymer (P), and then inducing the curing of the prepolymer (P) by heating to a temperature of between 150°C and 300°C.

7. Process according to any one of claims 1 to 6, characterized in that the optional reactant (c), when used, is employed in quantities representing less than 60 % of the total weight of the reactants (a) + (b).

8. Process according to any one of claims 1 to 6, characterized in that the optional imidazole compound (d), when used, is employed in quantities which are situated in the range from 0.005 to 1 % by weight relative to the total of the reactants (a) + (b) + optionally (c).

**9.** Process according to any one of claims 1 to 8, characterized in that the quantity of chlorine or of bromine contributed by the additive (e), expressed as the weight percentage of elemental chlorine or of elemental bromine relative to the weight of the overall mixture of bisimide(s) (a) + diamine(s) (b) + optional reactant (c) + additive (e), represents not more than 6 %.